# EUROPEAN PATENT APPLICATION

(11) **EP 4 704 083 A1**
(43) Date of publication of application: **04.03.2026**
(21) Application number: 25182255.7
(22) Date of filing: 12.06.2025
(51) Int. Cl.: G11C 5/04, H01L 23/14, H01L 23/28, H01L 23/31, H01L 23/498, H01L 25/065

(54) **SEMICONDUCTOR CHIP AND SEMICONDUCTOR PACKAGE INCLUDING THE SAME**

(30) Priority: 30.08.2024 KR 20240117942
(71) Applicant: Samsung Electronics Co., Ltd., Suwon-si, Gyeonggi-do 16677 (KR)
(72) Inventor: BAEK, Seungduk, Suwon-si, Gyeonggi-do 16677 (KR)
(74) Representative: Kuhnen & Wacker Patent- und Rechtsanwaltsbüro PartG mbB

(57) **Abstract**

Provided is a semiconductor chip (100) including a semiconductor substrate (110) including a first surface (110_A) and a second surface (110_UA) opposite to the first surface (110_A), a wiring layer (120) arranged on the first surface (110_A) of the semiconductor substrate (110), a plurality of through electrodes (140) extending from the first surface (110_A) of the semiconductor substrate (110) to the second surface (110_UA) of the semiconductor substrate (110), a plurality of chip pads (130_P) arranged on the second surface (110_UA) of the semiconductor substrate (110) and electrically connected to the plurality of through electrodes (140), and a passivation layer (130) arranged on the second surface (110_UA) of the semiconductor substrate (110) and in contact with side surfaces of the plurality of chip pads (130_P). The passivation layer (130) includes an insulating layer (131) and an oxide layer (132) arranged on the insulating layer (131). The insulating layer (131) includes an insulating pattern having a first width along a horizontal direction. The oxide layer (132) includes a first oxide pattern having a second width along the horizontal direction. The first width is greater than the second width.

## Description

### BACKGROUND

The inventive concept relates to a semiconductor chip and a semiconductor package, and more particularly, to a semiconductor chip including a through electrode and a semiconductor package including the semiconductor chip.

According to the rapid development in the electronic industry and user demands, electronic devices have been miniaturized and multi-functionalized with larger capacity, which requires higher integrated semiconductor chips. As a result, semiconductor packages including highly integrated semiconductor chips with more connection terminals for input/output (I/O) and having secured connection reliability have been developed.

### SUMMARY

Aspects of the inventive concept provide a semiconductor chip with improved adhesive force with a molding layer and a semiconductor package including the semiconductor chip.

The object, which the technical ideas of the inventive concept seek to achieve, is not limited to the foregoing, and other objects may be clearly understood by a person skilled in the art from the description below.

According to an aspect of the inventive concept, there is provided a semiconductor chip including a semiconductor substrate including a first surface and a second surface opposite to the first surface, a wiring layer arranged on the first surface of the semiconductor substrate, a plurality of through electrodes extending from the first surface of the semiconductor substrate to the second surface of the semiconductor substrate, a plurality of chip pads arranged on the second surface of the semiconductor substrate and electrically connected to the plurality of through electrodes, and a passivation layer arranged on the second surface of the semiconductor substrate and in contact with side surfaces of the plurality of chip pads. The passivation layer includes an insulating layer and an oxide layer arranged on the insulating layer. The insulating layer includes an insulating pattern having a first width along a horizontal direction. The oxide layer includes a first oxide pattern having a second width along the horizontal direction. The first width is greater than the second width.

According to another aspect of the inventive concept, there is provided a semiconductor chip including a semiconductor substrate including a first surface and a second surface opposite to the first surface, a wiring layer arranged on the first surface of the semiconductor substrate, a plurality of through electrodes extending from the first surface of the semiconductor substrate to the second surface of the semiconductor substrate, a plurality of chip pads arranged on the second surface of the semiconductor substrate and electrically connected to the plurality of through electrodes, and a passivation layer arranged on the second surface of the semiconductor substrate and in contact with side surfaces of the plurality of chip pads and including an insulating layer and an oxide layer arranged on the insulating layer. A surface area of an upper surface of the oxide layer is less than a surface area of an upper surface of the insulating layer. The semiconductor substrate has a first region and a second region surrounding the first region in a plan view. The first region has a rectangular shape in a plan view. The oxide layer is disposed on the first and second regions. The oxide layer includes an opening located on the second region. The opening is recessed from the upper surface of the oxide layer to a lower surface of the oxide layer. The oxide layer includes a first oxide pattern, the insulating layer includes an insulating pattern. In a plan view, side surfaces of the first oxide pattern are arranged within the insulating pattern, and are arranged apart from side surfaces of the insulating pattern.

According to another aspect of the inventive concept, there is provided a semiconductor package including a first semiconductor chip. The first semiconductor chip includes a first semiconductor substrate including a first surface and a second surface opposite to the first surface, a plurality of first through electrodes passing through the first semiconductor substrate, a passivation layer arranged on the second surface of the first semiconductor substrate, and a plurality of first chip pads in contact with the plurality of first through electrodes and surrounded by the passivation layer. The semiconductor package further includes a second semiconductor chip stacked on the first semiconductor chip and having a width less than a width of the first semiconductor chip, and a molding layer arranged on the passivation layer of the first semiconductor chip and in contact with at least a part of a side surface of the second semiconductor chip. The passivation layer of the first semiconductor chip includes an insulating layer and an oxide layer arranged on the insulating layer. The insulating layer includes an insulating pattern having a first width along a horizontal direction. The oxide layer includes a first oxide pattern having a second width along the horizontal direction. The first width is greater than the second width. In a plan view, side surfaces of the first oxide pattern of the passivation layer are arranged within the insulating pattern of the passivation layer. The second semiconductor chip is in contact with the first oxide pattern of the passivation layer of the first semiconductor chip.

According to another aspect of the inventive concept, there is provided a method of manufacturing a semiconductor package, the method including mounting a first semiconductor substrate on a carrier substrate such that a first surface of the first semiconductor substrate is directed towards the carrier substrate, forming a passivation layer on a second surface of the first semiconductor substrate, forming a plurality of first chip pads on the passivation layer such that the plurality of first chip pads are electrically connected to a plurality of first through electrodes passing through the first semiconductor substrate, forming a trench extending from an upper surface of the passivation layer to an inside of the passivation layer such that a sidewall of the trench is arranged apart from side surfaces of the plurality of first chip pads, mounting a semiconductor chip on the passivation layer, and forming a molding layer on the passivation layer to surround the semiconductor chip.

### BRIEF DESCRIPTION OF THE DRAWINGS

Embodiments will be more clearly understood from the following detailed description taken in conjunction with the accompanying drawings in which:
FIG. 1 is a plan view schematically illustrating a first semiconductor chip according to an embodiment;
FIG. 2 is a cross-sectional view schematically illustrating the first semiconductor chip of FIG. 1 cut along line A-A' of FIG. 1;
FIG. 3 is an enlarged view schematically illustrating part EX1 of the first semiconductor chip of FIG. 2;
FIG. 4 is a cross-sectional view schematically illustrating a first semiconductor chip according to an embodiment;
FIG. 5 is a plan view schematically illustrating a first semiconductor chip according to an embodiment;
FIG. 6 is a cross-sectional view schematically illustrating the first semiconductor chip of FIG. 5 cut along line B-B' of FIG. 5;
FIG. 7 is an enlarged view schematically illustrating part EX2 of the first semiconductor chip of FIG. 6;
FIG. 8 is a cross-sectional view schematically illustrating a first semiconductor chip according to an embodiment;
FIG. 9 is a plan view schematically illustrating a first semiconductor chip according to an embodiment;
FIG. 10 is a plan view schematically illustrating a first semiconductor chip according to an embodiment;
FIG. 11 is a plan view schematically illustrating a first semiconductor chip according to an embodiment;
FIG. 12 is a cross-sectional view schematically illustrating a semiconductor package according to an embodiment;
FIG. 13 is a cross-sectional view schematically illustrating a semiconductor package according to an embodiment;
FIG. 14 is a cross-sectional view schematically illustrating a semiconductor package according to an embodiment; and
FIGS. 15A to 15G are each a diagram illustrating a method of manufacturing a semiconductor package, according to an embodiment.

### DETAILED DESCRIPTION OF THE EMBODIMENTS

As the inventive concept allows for various changes and numerous embodiments, embodiments will be illustrated in the drawings and described in detail in the written description. However, this is not intended to limit the invention to particular descriptions.

Items described in the singular herein may be provided in plural, as can be seen, for example, in the drawings. Thus, the description of a single item that is provided in plural should be understood to be applicable to the remaining plurality of items unless context indicates otherwise.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

Terms such as "same," "identical," "equal," "planar," "coplanar," "parallel," and "perpendicular," as used herein encompass identicality or near identicality including variations that may occur resulting from conventional manufacturing processes. The term "substantially" may be used herein to emphasize this meaning, unless the context or other statements indicate otherwise.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

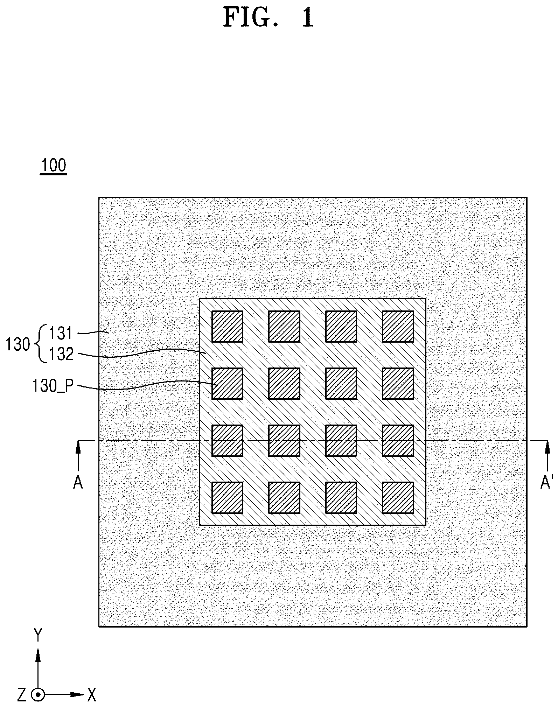

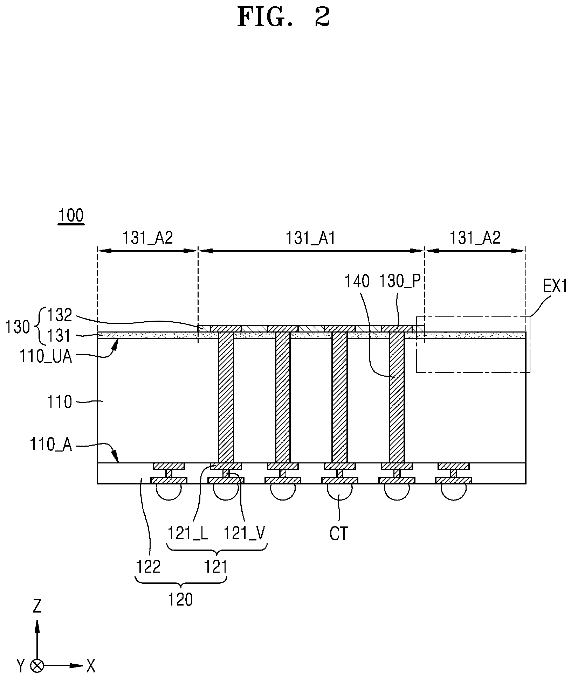

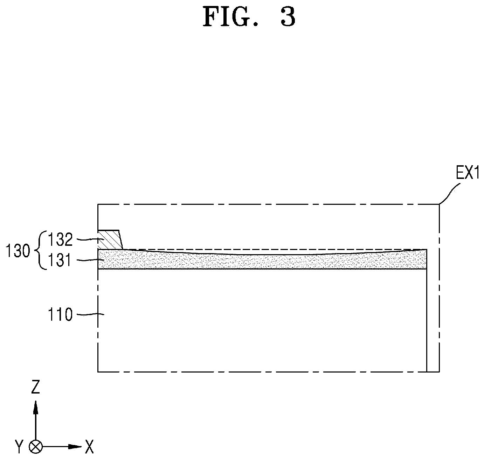

FIG. 1 is a plan view schematically illustrating a first semiconductor chip 100 according to an embodiment. FIG. 2 is a cross-sectional view schematically illustrating the first semiconductor chip 100 of FIG. 1 cut along line A-A' of FIG. 1. FIG. 3 is an enlarged view schematically illustrating part EX1 of the first semiconductor chip 100 of FIG. 2.

Referring to FIGS. 1 to 3, the first semiconductor chip 100 may include a first semiconductor substrate 110, a first wiring structure 120, a plurality of first through electrodes 140, a plurality of first chip pads 130_P, and a first passivation layer 130.

Unless otherwise defined, a direction parallel to an upper surface of the first semiconductor substrate 110 is defined as a first horizontal direction (X direction), a direction perpendicular to the upper surface of the first semiconductor substrate 110 is defined as a vertical direction (Z direction), and a direction perpendicular to both the first horizontal direction (X direction) and the vertical direction (Z direction) is defined as a second horizontal direction (Y direction). A direction obtained by combining the first horizontal direction (X direction) and the second horizontal direction (Y direction) is defined as a horizontal direction.

The first semiconductor substrate 110 may include an active surface 110_A and an inactive surface 110_UA. In some embodiments, the active surface 110_A of the first semiconductor substrate 110 may be referred to as a front surface of the first semiconductor substrate 110, and the inactive surface 110_UA of the first semiconductor substrate 110 may be referred to as a rear surface of the first semiconductor substrate 110.

The first semiconductor substrate 110 may include, for example, a semiconductor material such as silicon (Si) or, alternatively, germanium (Ge).

An integrated circuit including a plurality of individual devices (components) of various types may be formed on the active surface 110_A of the first semiconductor substrate 110. The plurality of individual devices formed on the first semiconductor substrate 110 may include microelectronic devices, for example, a metal-oxide-semiconductor field effect transistor (MOSFET) or complementary metal-oxide-semiconductor (CMOS) transistors. For example, the integrated circuit may include a large-scale integration (LSI), an image sensor (e.g., a CMOS imaging sensor (CIS)), a micro-electro-mechanical system (MEMS), an active device, and/or a passive device.

The first wiring structure 120 may be a first wiring layer, which is arranged on the active surface 110_A of the first semiconductor substrate 110. The first wiring structure 120 may be electrically connected to a semiconductor device arranged on the active surface 110_A of the first semiconductor substrate 110.

The first wiring structure 120 may be a composite layer, which includes a first wiring pattern 121 and a first wiring insulating layer 122 surrounding the first wiring pattern 121. The first wiring pattern 121 may include a first wiring line 121_L extending in the horizontal direction and a first wiring via 121_V extending in a vertical direction (Z direction) from the first wiring line 121_L. The first wiring pattern 121 may be electrically connected to a plurality of individual devices of the first semiconductor substrate 110.

A part of the first wiring line 121_L of the first wiring pattern 121 of the first wiring structure 120 may be exposed to the outside (outside environment). For example, the part of the first wiring line 121_L exposed to the outside may be referred to as a first front pad. External connection terminals CT may be attached to the first front pad. For example, each of the first front pads may be electrically connected to a corresponding one the first through electrodes 140.

The external connection terminals CT may electrically and physically connect the first semiconductor chip 100 with an external device on which the first semiconductor chip 100 is mounted. The external connection terminals CT may be or be formed from, for example, a solder ball or a solder bump.

Each of the plurality of first through electrodes 140 may extend to the inactive surface 110_UA of the first semiconductor substrate 110 from the active surface 110_A of the first semiconductor substrate 110. For example, each of the plurality of first through electrodes 140 may pass through at least a part of the first semiconductor substrate 110. For example, the plurality of first through electrodes 140 may be electrically connected to the first wiring structure 120.

The plurality of first chip pads 130_P may be arranged on the inactive surface 110_UA of the first semiconductor substrate 110. The first chip pad 130_P may also be referred to as a first rear pad. For example, the plurality of first chip pads 130_P may be exposed to the outside. For example, a lower surface of each of the plurality of first chip pads 130_P may be in contact with the plurality of first through electrodes 140, and an upper surface of each of the plurality of first chip pads 130_P may be exposed to the outside.

Each of the plurality of first chip pads 130_P may be electrically connected to each of the plurality of first through electrodes 140. For example, the plurality of first chip pads 130_P may respectively correspond to the plurality of first through electrodes 140. For example, each of the plurality of first chip pads 130_P may be electrically connected to a corresponding one of the first through electrodes 140. For example, although FIG. 2 illustrates that the plurality of first chip pads 130_P are distinguished from the plurality of first through electrodes 140, the plurality of first chip pads 130_P may be integrated with the plurality of first through electrodes 140. For example, a corresponding pair of first chip pad 130_P and first through electrode 140 may be integrally formed (together) of the same material without a boundary interface therebetween.

In some embodiments, the plurality of first through electrodes 140 and the plurality of first chip pads 130_P may include copper, nickel, stainless steel, or beryllium copper.

The first passivation layer 130 may be arranged on the inactive surface 110_UA of the first semiconductor substrate 110. For example, the first passivation layer 130 may be arranged apart from the first wiring structure 120 with the first semiconductor substrate 110 located therebetween. For example, the first passivation layer 130 may be referred to as a rear passivation layer.

The first passivation layer 130 may surround the plurality of first chip pads 130_P. For example, the first passivation layer 130 may be in contact with side surfaces of the plurality of first chip pads 130_P. The first passivation layer 130 may protect the plurality of first chip pads 130_P from the outside.

The first passivation layer 130 may include an insulating layer 131 and an oxide layer 132. The oxide layer 132 may be arranged on the insulating layer 131. For example, a lower surface of the insulating layer 131 may be in contact with the first semiconductor substrate 110 and an upper surface of the insulating layer 131 may be in contact with the oxide layer 132. In some embodiments, the hardness of the insulating layer 131 may be greater than the hardness of the oxide layer 132. For example, the insulating layer 131 may include a silicon nitride. The oxide layer 132 may include a silicon oxide.

The width of the oxide layer 132 may be less than the width of the insulating layer 131. The side surfaces of the insulating layer (or insulating pattern) 131 may be aligned with the side surfaces of the first semiconductor substrate 110 in the vertical direction (Z direction). The side surfaces of the oxide layer 132 may overlap the upper surface of the insulating layer 131 in the vertical direction (Z direction). The side surfaces of the oxide layer 132 may be arranged apart from the side surfaces of the insulating layer 131. For example, a part of the upper surface of the insulating layer 131 may not be covered by the oxide layer 132.

In some embodiments, the insulating layer 131 may include an insulating pattern. In a plan view, the side surfaces of the insulating pattern of the first passivation layer 130 may be aligned with the side surfaces of the first semiconductor substrate 110. The oxide layer 132 may include an oxide pattern. In a plan view, side surfaces of the oxide pattern of the first passivation layer 130 may be arranged within the insulating pattern of the first passivation layer 130. The insulating pattern and the oxide pattern may have first and second widths along a horizontal direction, respectively. The first width may be greater than the second width. The oxide pattern may have a through hole in which the first chip pads 130_P is disposed.

The thickness of the first passivation layer 130 may include areas having different thicknesses from each other. For example, the thickness (i.e., the vertical dimension) of the combination of the insulating layer 131 and the oxide layer 132 may vary across different areas. For example, the first passivation layer 130 may include an area in which both of the oxide layer 132 and the insulating layer 131 are present and another area in which only the insulating layer 131 is present, and the two areas may have different thicknesses from each other. The thickness of the first passivation layer 130 in the area where the oxide layer 132 and the insulating layer 131 are both present may be greater than the thickness of the first passivation layer 130 in the area where only the insulating layer 131 is present.

In some embodiments, the insulating layer 131 of the first passivation layer 130 may have a first area 131_A1 and a second area 131_A2 surrounding the first area 131_A1 in a plan view. In the first area 131_A1 of the insulating layer 131, the upper surface of the insulating layer 131 may be covered by the oxide layer 132, and in the second area 131_A2 of the insulating layer 131, the upper surface of the insulating layer 131 may be exposed to the outside. For example, a part of the first passivation layer 130, which is disposed in the first area 131_A1 of the insulating layer 131 in a plan view, may be thicker than a part of the first passivation layer 130, which is disposed in the second area 131_A2 of the insulating layer 131 in a plan view.

For example, in a plan view, the first area 131_A1 of the insulating layer 131 may include (encompass) a center of the upper surface of the insulating layer 131, and the second area 131_A2 of the insulating layer 131 may include sides of the upper surface of the insulating layer 131. For example, in a plan view, the second area 131_A2 of the insulating layer 131 may encompass a peripheral region of the upper surface of the insulating layer 131. The first area 131_A1 of the insulating layer 131 may be referred to as a central area, and the second area 131_A2 of the insulating layer 131 may be referred to as an edge area.

The plurality of first through electrodes 140 and the plurality of first chip pads 130_P may overlap the first area 131_A1 of the insulating layer 131 of the first passivation layer 130 in the vertical direction (Z direction). For example, the upper surfaces of the plurality of first chip pads 130_P may be arranged on the same plane as the upper surface of the oxide layer 132 of the first passivation layer 130. The plurality of first through electrodes 140 and the plurality of first chip pads 130_P may be arranged apart from the part of the first passivation layer 130, in which the oxide layer 132 is not present. The plurality of first through electrodes 140 and the plurality of first chip pads 130_P may be arranged apart from the second area 131_A2 of the insulating layer 131 of the first passivation layer 130 in the horizontal direction.

Referring to FIG. 3, the shapes of the oxide layer 132 and the insulating layer 131 of the first passivation layer 130 are described.

The oxide layer 132 of the first passivation layer 130 may have a width which varies according to a distance to the insulating layer 131. The oxide layer 132 may have a horizontal width which increases as it becomes adjacent to the insulating layer 131. For example, the side surface of the oxide layer 132 and the upper surface of the oxide layer 132 may form an obtuse angle. In some embodiments, in the process of forming the oxide layer 132, a photo process may be performed on the oxide layer 132, and the width of the oxide layer 132 may increase downwards in the vertical direction (Z direction). For example, the oxide layer 132 may be patterned to form an oxide pattern, which has a trapezoidal vertical cross-section. The oxide pattern may have a width in a horizontal direction increasing from top surface to bottom surface thereof. The width at the top surface is less than that at the bottom surface. Sidewalls of the oxide pattern may have slope relative to the upper surface of the first semiconductor substrate 110. The first area 131_A1 of the insulating layer 131 may be covered by the oxide layer 132, and the second area 131_A2 of the insulating layer 131 may be exposed to the outside. In the first area 13 1_A1 of the insulating layer 131, the upper surface of the insulating layer 131 may have a flat shape, and in the second area 131_A2 of the insulating layer 131, the upper surface of the insulating layer 131 may have a downward-concave shape.

In some embodiments, by performing the photo process on the insulating layer 131 and the oxide layer 132, which are formed conformally on the inactive surface 110_UA of the first semiconductor substrate 110, the oxide layer 132 may be partially removed such that the second area 131_A2 of the insulating layer 131 is exposed to the outside. During the photo process, in the first area 131_A1 of the insulating layer 131, the upper surface of the insulating layer 131 may be located and protected under the oxide layer 132 and maintain the flat shape. On the other hand, during the photo process (and related etching process), in the second area 131_A2 of the insulating layer 131, the upper surface of the insulating layer 131 may be partially removed along with the oxide layer 132, and the upper surface of the insulating layer 131 may have a downward-concave shape in the second area 13 1_A2 of the insulating layer 131.

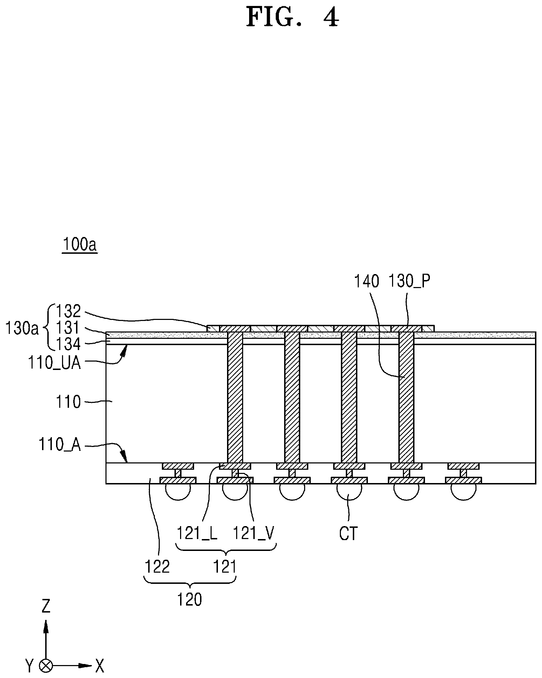

FIG. 4 is a cross-sectional view schematically illustrating a first semiconductor chip 100a according to an embodiment.

Most of the components constituting the first semiconductor chip 100a and the materials included in the components described below may be substantially identical or similar to the components and materials described above with reference to FIG. 2. Accordingly, for convenience, embodiments are described focusing on differences between the first semiconductor chip 100a of FIG. 4 and the first semiconductor chip 100 of FIG. 2.

Referring to FIG. 4, the first semiconductor chip 100a may include the first semiconductor substrate 110, the first wiring structure 120, the plurality of first through electrodes 140, the plurality of first chip pads 130_P, and a first passivation layer 130a.

The plurality of first through electrodes 140 may extend to the inactive surface 110_UA of the first semiconductor substrate 110 from the active surface 110_A of the first semiconductor substrate 110. In some embodiments, a part of each of the plurality of first through electrodes 140 may protrude over the inactive surface 110_UA of the first semiconductor substrate 110.

The plurality of first chip pads 130_P may be arranged on the parts of the plurality of first through electrodes 140 which protrude to the outside of the first semiconductor substrate 110. For example, the plurality of first chip pads 130_P may be arranged on the upper surfaces of the plurality of first through electrodes 140. In some embodiments, the plurality of first chip pads 130_P may be integrated with the plurality of first through electrodes 140.

The first passivation layer 130a may include an intermediate oxide layer 134, the insulating layer 131, and the oxide layer 132. The intermediate oxide layer 134 may be arranged on the inactive surface 110_UA of the first semiconductor substrate 110, the insulating layer 131 may be arranged on the upper surface of the intermediate oxide layer 134, and the oxide layer 132 may be arranged on the upper surface of the insulating layer 131. For example, the intermediate oxide layer 134 may be arranged between the insulating layer 131 and the first semiconductor substrate 110. The intermediate oxide layer 134 may be arranged between the insulating layer 131 and the first semiconductor substrate 110 to suppress delamination of the insulating layer 131. For example, the intermediate oxide layer 134 may include a silicon oxide, the insulating layer 131 may include a silicon nitride, and the oxide layer 132 may include a silicon oxide.

In some embodiments, the width of the intermediate oxide layer 134 may be substantially identical to the width of the insulating layer 131. The side surfaces of the intermediate oxide layer 134 may be aligned with the side surfaces of the first semiconductor substrate 110 in the vertical direction (Z direction). In some embodiments, the width of the oxide layer 132 may be less than the width of the insulating layer 131. The side surfaces of the oxide layer 132 may overlap the upper surface of the insulating layer 131 in the vertical direction. For example, the intermediate oxide layer 134 may include an intermediate oxide pattern. In a plan view, side surfaces of an oxide pattern of the oxide layer 132 may be arranged within the intermediate oxide pattern.

In some embodiments, the first passivation layer 130a may surround the plurality of first through electrodes 140 and the plurality of first chip pads 130_P. In some embodiments, the oxide layer 132 of the first passivation layer 130a may surround the side surfaces of the plurality of first chip pads 130_P, and the insulating layer 131 and the intermediate oxide layer 134 may partially surround the side surfaces of the plurality of first through electrodes 140.

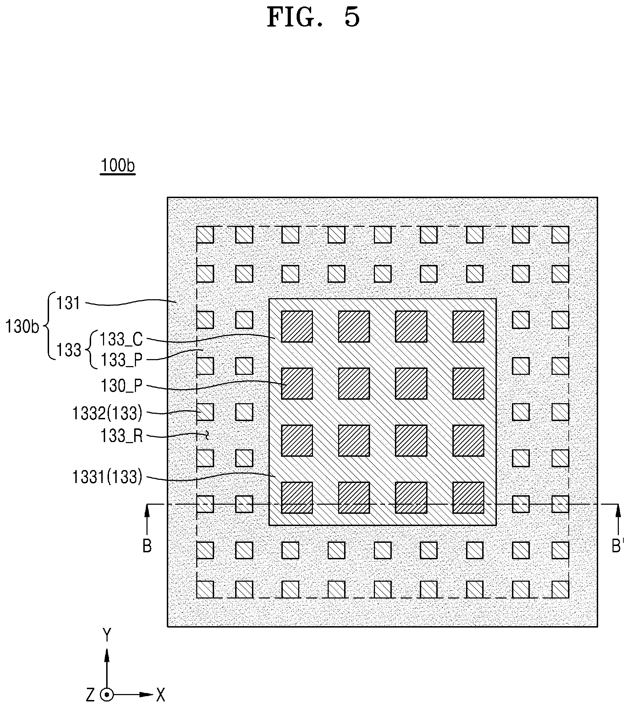

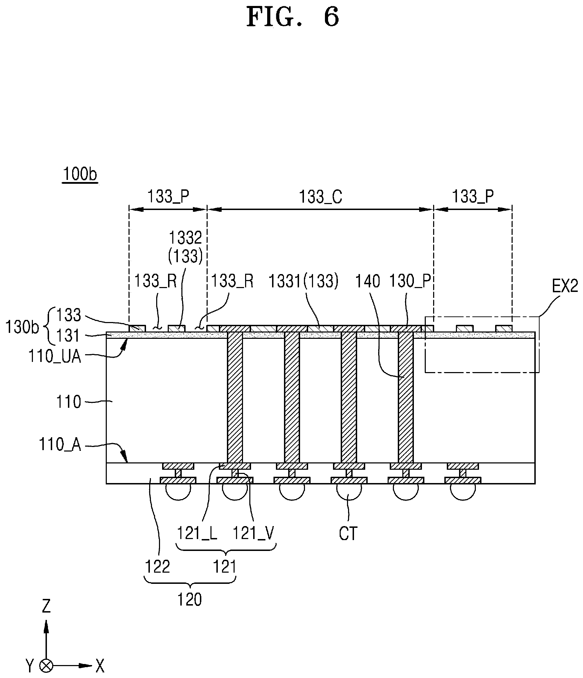

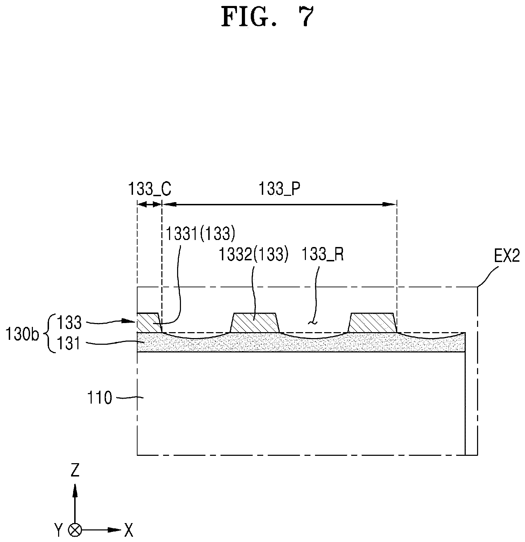

FIG. 5 is a plan view schematically illustrating a first semiconductor chip 100b according to an embodiment. FIG. 6 is a cross-sectional view schematically illustrating the first semiconductor chip 100b of FIG. 5 cut along line B-B' of FIG. 5. FIG. 7 is an enlarged view schematically illustrating part EX2 of the first semiconductor chip 100b of FIG. 6.

Most of the components constituting the first semiconductor chip 100b and the materials included in the components described below may be substantially identical or similar to the components and materials described above with reference to FIG. 2. Accordingly, for convenience, embodiments are described focusing on differences between the first semiconductor chip 100b of FIG. 6 and the first semiconductor chip 100 of FIG. 2.

Referring to FIGS. 5 to 7, the first semiconductor chip 100b may include the first semiconductor substrate 110, the first wiring structure 120, the plurality of first through electrodes 140, the plurality of first chip pads 130_P, and a first passivation layer 130b.

The first semiconductor substrate 110 may include the active surface 110_A on which a plurality of individual devices are arranged and the inactive surface 110_UA which is opposite to the active surface 110_A. For example, the active surface 110_A of the first semiconductor substrate 110 may be referred to as a front surface, and the inactive surface 110_UA of the first semiconductor substrate 110 may be referred to as a rear surface.

The first wiring structure 120 may be arranged on the active surface 110_A of the first semiconductor substrate 110. The first wiring structure 120 may be electrically connected to the plurality of individual devices on the active surface 110_A of the first semiconductor substrate 110.

The first wiring structure 120 may include the first wiring pattern 121 and the first wiring insulating layer 122 surrounding the first wiring pattern 121. The first wiring pattern 121 may include the first wiring line 121_L extending in the horizontal direction and the first wiring via 121_V extending in the vertical direction (Z direction) from the first wiring line 121_L. A part arranged at a lowermost portion of the first wiring line 121_L and exposed to the outside may be referred to as a first front pad. The external connection terminals CT may be attached to the first front pad.

The plurality of first through electrodes 140 may extend to the inactive surface 110_UA of the first semiconductor substrate 110 from the active surface 110_A of the first semiconductor substrate 110. For example, the plurality of first through electrodes 140 may be connected to the plurality of individual devices of the first semiconductor substrate 110 and the first wiring structure 120.

The plurality of first chip pads 130_P may be arranged on the upper surfaces of the plurality of first through electrodes 140. In some embodiments, the width of the plurality of first chip pads 130_P may be greater than the width of the plurality of first through electrodes 140. The plurality of first chip pads 130_P may be arranged on the inactive surface 110_UA of the first semiconductor substrate 110, and the plurality of first chip pads 130_P may be referred to as a plurality of first rear pads.

The first passivation layer 130b may be arranged on the inactive surface 110_UA of the first semiconductor substrate 110. The first passivation layer 130b may be arranged apart from the first wiring structure 120 in the vertical direction (Z direction). For example, the first passivation layer 130b may be arranged apart from the first wiring structure 120 with the first semiconductor substrate 110 located therebetween.

For example, the first passivation layer 130b may be in contact with the side surfaces of the plurality of first chip pads 130_P. The first passivation layer 130b may protect the plurality of first chip pads 130_P from the outside. For example, the first passivation layer 130b may be referred to as a rear passivation layer.

The first passivation layer 130b may include the insulating layer 131 and an oxide layer 133 arranged on the insulating layer 131. The hardness of the insulating layer 131 may be greater than the hardness of the oxide layer 133. For example, the insulating layer 131 may include a silicon nitride, and the oxide layer 133 may include a silicon oxide.

The width of the insulating layer 131 may be identical to the width of the first semiconductor substrate 110, and the width of the oxide layer 133 may be less than the width of the insulating layer 131. The side surfaces of the oxide layer 133 may overlap the upper surface of the insulating layer 131 in the vertical direction (Z direction). The side surfaces of the oxide layer 133 may be arranged apart from the side surfaces of the insulating layer 131. For example, a part of the upper surface of the insulating layer 131 may be covered by the oxide layer 133, and the rest of the upper surface of the insulating layer 131 may be exposed to the outside.

The central area of the insulating layer 131 may be covered by the oxide layer 133, and the edge area of the insulating layer 131 may be exposed to the outside. A part of the upper surface of the insulating layer 131, which is located on the edge of the oxide layer 133 may be exposed to the outside. For example, a part of the upper surface of the insulating layer 131, which is located outer than the side surface of a peripheral area 133_P of the oxide layer 133 may be exposed to the outside.

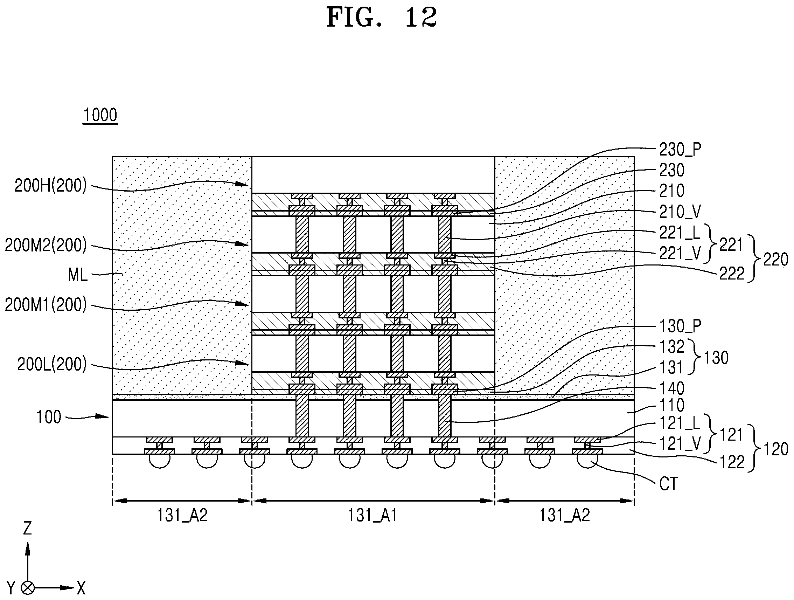

The oxide layer 133 may include a plane area 133_C and the peripheral area 133_P. The peripheral area 133_P may surround the plane area 133_C. For example, the plane area 133_C of the oxide layer 133 may include a center of an upper surface of the oxide layer 133, and the peripheral area 133_P of the oxide layer 133 may include a side surface of the oxide layer 133. In some embodiments, the plane area 133_C of the oxide layer 133 may be an area in which a second semiconductor chip 200 (see FIG. 12) is stacked.

For example, the first semiconductor substrate 110 may have a first region and a second region surrounding the first region. The first region has a rectangular shape (solid rectangle) in a plan view. The second region has a rectangular ring shape in a plan view. the second semiconductor chip 200 (see FIG. 12) may overlap the rectangular shaped first region in a plan view.

In the peripheral area 133_P of the oxide layer 133 (or on the second region), a recess groove (opening) 133_R recessed towards the lower surface of the oxide layer 133 from the upper surface of the oxide layer 133 may be arranged. A part of the upper surface of the insulating layer 131, which is located at a lower portion of the recess groove 133_R of the oxide layer 133 may be exposed to the outside. For example, a part of the upper surface of the insulating layer 131 may be exposed to the outside by the recess groove 133_R.A part of the oxide layer 133 located in the plane area 133_C of the oxide layer 133 may be referred to as a plane (or a first oxide pattern) 1331. A part of the oxide layer 133 located in the peripheral area 133_P of the oxide layer 133 may be referred to as a plurality of second oxide patterns 1332 1332. For example, in the peripheral area 133_P of the oxide layer 133, a part of the oxide layer 133, which is not recessed may be referred to as the plurality of second oxide patterns 1332.

For example, the oxide layer 133 may be disposed on the first and second regions. The plane area 1331 and the peripheral area 133_P correspond to the first and second regions, respectively. The oxide layer 133 may include a plurality of oxide patterns. The plurality of oxide patterns may include the first oxide pattern 1331 and the plurality of second oxide patterns 1332. The first oxide pattern 1331 may be disposed on the first region, and the plurality of second oxide patterns 1332 may be disposed on the second region. For example, in the first region, the upper surface of the insulating layer 131 may be covered by the oxide layer 133. In the second region, a portion of the upper surface of the insulating layer 131 may be covered by the plurality of second oxide patterns, and the other portion of the upper surface of the insulating layer 131 may be exposed with respect to the oxide layer 133.

A vertical level of an upper surface of the plane 1331 may be identical to a vertical level of an upper surface of each of the plurality of second oxide patterns 1332. For example, the plurality of second oxide patterns 1332 may be an un-recessed area of the oxide layer 133 and may be substantially identical to the plane 1331. For example, the plane 1331 and the plurality of second oxide patterns 1332 may be a remaining (unremoved) portion of the oxide layer 133, after patterning (partially removing) of the oxide layer 133.

The plurality of first chip pads 130_P may be arranged in the plane area 133_C of the oxide layer 133. For example, the plurality of first through electrodes 140 may be located under the plurality of first chip pads 130_P and may overlap the plane area 133_C of the oxide layer 133 in the vertical direction (Z direction). For example, each of the plurality of first chip pads 130_P may be in contact with a corresponding one of the plurality of first through electrodes and surrounded by the passivation layer 130b. The oxide layer 133 may be in contact with side surfaces of the plurality of chip pads. Sidewalls of the oxide pattern may have slope relative to the upper surface of the first semiconductor substrate 110.

Referring to FIG. 7, in the plane area 133_C of the oxide layer 133, the width of the plane (the first oxide pattern) 1331 may increase towards the insulating layer 131. In the peripheral area 133_P of the oxide layer 133, the width of each of the plurality of second oxide patterns 1332 may increase towards the insulating layer 131.

A first part of the upper surface of the insulating layer 131 of the first passivation layer 130b, which is located at the lower portion of the recess groove 133_R of the oxide layer 133 and a second part of the upper surface of the insulating layer 131 of the first passivation layer 130b, which is located on the edge of the oxide layer 133 may be exposed to the outside. The first and second parts of the upper surface of the insulating layer 131, which is exposed to the outside, may have a downward-concave shape. For example, in the process of partially removing the oxide layer 133 to expose the upper surface of the insulating layer 131, a part of the upper surface of the insulating layer 131 may be removed and may have a downward-concave shape.

Referring to FIG. 5, the plurality of second oxide patterns 1332 may be arranged apart from the plane 1331 in the horizontal direction. The plurality of second oxide patterns 1332 may be arranged apart from each other in the horizontal direction. For example, the upper surfaces of the plurality of second oxide patterns 1332 may have the same surface area. The plurality of second oxide patterns 1332 may be spaced apart from each other at (by) a certain distance. In some embodiments, the upper surface of each of the plurality of second oxide patterns 1332 may have a tetragonal shape.

In some embodiments, in the peripheral area 133_P of the oxide layer 133, the surface area of the upper surface of the oxide layer 133 may refer to the sum of surface areas of the upper surfaces of the plurality of second oxide patterns 1332. In the peripheral area 133_P of the oxide layer 133, the surface area of the upper surface of the oxide layer 133 may be less than the surface area of a part of the upper surface of the insulating layer 131, which is exposed to the outside. The sum of the upper surfaces of the plurality of second oxide patterns 1332 may be less than the surface area of the part of the upper surface of the insulating layer 131, which is exposed to the outside.

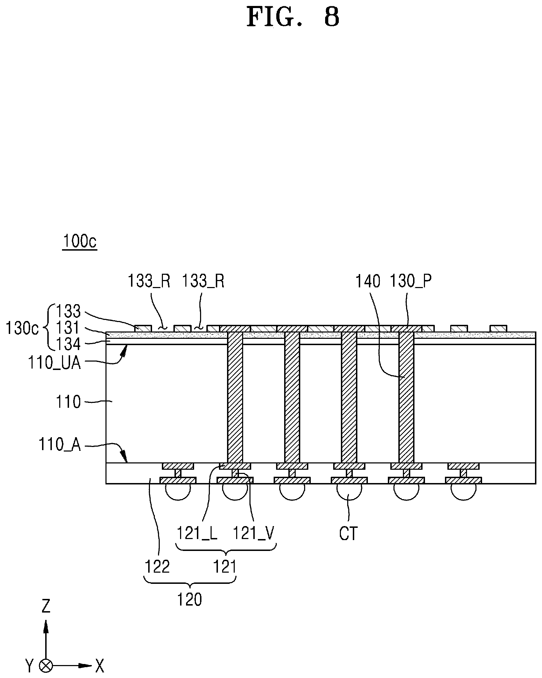

FIG. 8 is a cross-sectional view schematically illustrating a first semiconductor chip 100c according to an embodiment.

Most of the components constituting the first semiconductor chip 100c and the materials included in the components described below may be substantially identical or similar to the components and materials described above with reference to FIG. 6. Accordingly, for convenience, embodiments are described focusing on differences between the first semiconductor chip 100c of FIG. 8 and the first semiconductor chip 100b of FIG. 6.

Referring to FIG. 8, the first semiconductor chip 100c may include the first semiconductor substrate 110, the first wiring structure 120, the plurality of first through electrodes 140, the plurality of first chip pads 130_P, and a first passivation layer 130c.

The first passivation layer 130c may include the intermediate oxide layer 134, the insulating layer 131, and the oxide layer 133. The intermediate oxide layer 134 may be arranged on the inactive surface 110_UA of the first semiconductor substrate 110, the insulating layer 131 may be arranged on the upper surface of the intermediate oxide layer 134, and the oxide layer 133 may be arranged on the upper surface of the insulating layer 131. For example, the intermediate oxide layer 134 may be arranged between the insulating layer 131 and the first semiconductor substrate 110.

The intermediate oxide layer 134 may be arranged between the insulating layer 131 and the first semiconductor substrate 110 to suppress delamination of the insulating layer 131. For example, the intermediate oxide layer 134 may include a silicon oxide, the insulating layer 131 may include a silicon nitride, and the oxide layer 133 may include a silicon oxide.

In some embodiments, the width of the intermediate oxide layer 134 may be substantially identical to the width of the insulating layer 131. The side surfaces of the intermediate oxide layer 134 may be aligned with the side surfaces of the first semiconductor substrate 110 in the vertical direction (Z direction). In some embodiments, the width of the oxide layer 133 may be less than the width of the insulating layer 131. The side surfaces of the oxide layer 133 may overlap the upper surface of the insulating layer 131 in the vertical direction. For example, the intermediate oxide layer 134 may include an intermediate oxide pattern. In a plan view, side surfaces of a first oxide pattern of the oxide layer 133 may be arranged within the intermediate oxide pattern.

In some embodiments, the first passivation layer 130c may surround the plurality of first through electrodes 140 and the plurality of first chip pads 130_P. In some embodiments, the plane 1331 (see FIG. 6) of the oxide layer 133 of the first passivation layer 130c may surround the side surfaces of the plurality of first chip pads 130_P, and the insulating layer 131 and the intermediate oxide layer 134 may partially surround the side surfaces of the plurality of first through electrodes 140.

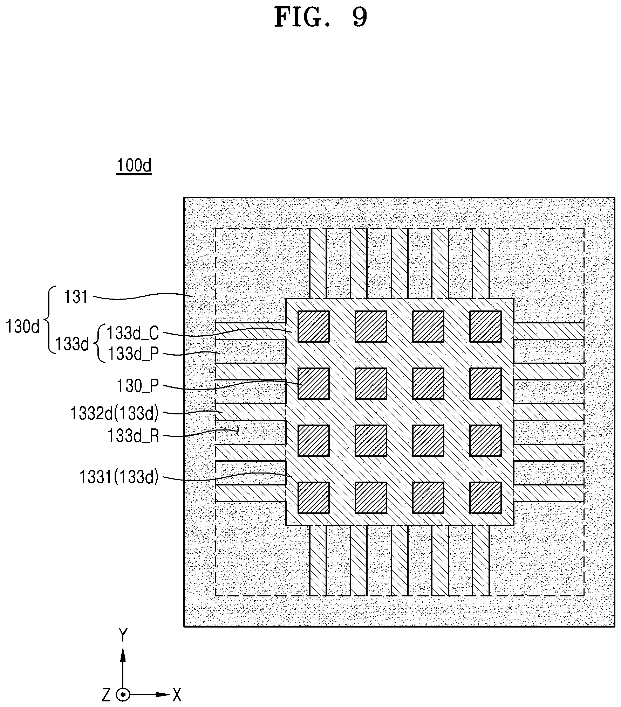

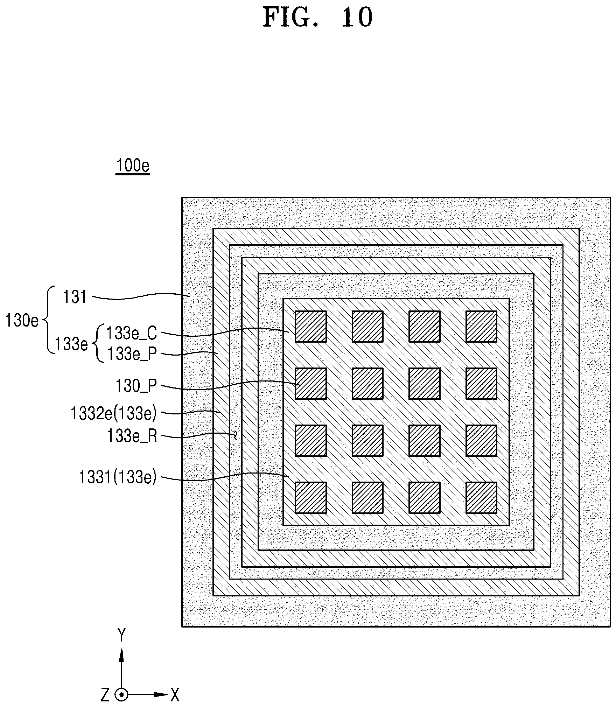

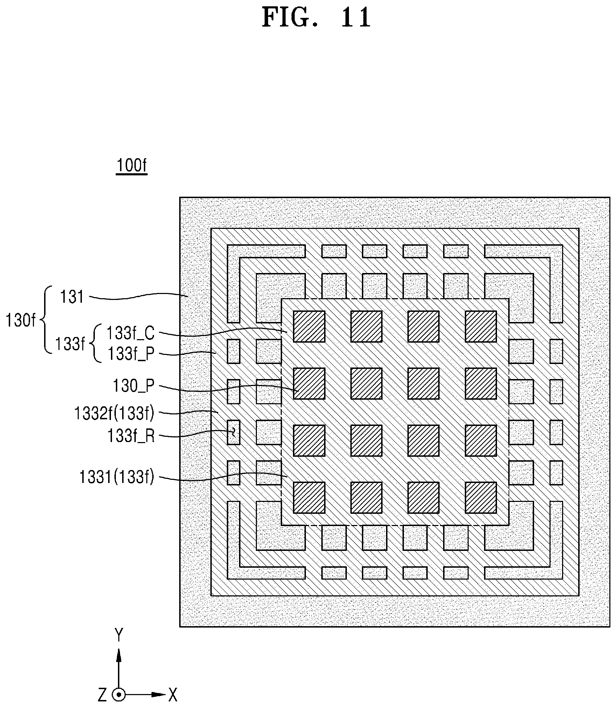

FIG. 9 is a plan view schematically illustrating a first semiconductor chip 100d according to an embodiment. FIG. 10 is a plan view schematically illustrating a first semiconductor chip 100e according to an embodiment. FIG. 11 is a plan view schematically illustrating a first semiconductor chip 100f according to an embodiment.

Most of the components constituting the first semiconductor chip (100d, 100e, and 100f) and the materials included in the components described below may be substantially identical or similar to the components and materials described above with reference to FIG. 5. Accordingly, for convenience, embodiments are described focusing on the difference between the first semiconductor chips 100d, 100e, and 100f of FIGS. 9 to 11 and the first semiconductor chip 100b of FIG. 5.

Referring to FIG. 9, a first passivation layer 130d may include the insulating layer 131 and an oxide layer 133d arranged on the insulating layer 131. The surface area of the upper surface of the oxide layer 133d may be less than the surface area of the upper surface of the insulating layer 131. A part of the upper surface of the insulating layer 131 may not be covered by the oxide layer 133d and may be exposed to the outside.

The oxide layer 133d may include a plane area 133d_C and a peripheral area 133d_P. The peripheral area 133d_P of the oxide layer 133d may surround the plane area 133d_C of the oxide layer 133d. The plane area 133d_C of the oxide layer 133d may include a center of the upper surface of the oxide layer 133d. For example, in a plan view, the plane area 133d_C of the oxide layer 133d may occupy a center of the upper surface of the insulating layer 131. The peripheral area 133d_P of the oxide layer 133d may include a recess groove (opening) 133d_R recessed towards the lower surface of the oxide layer 133d from the upper surface of the oxide layer 133d.

For example, a part of the oxide layer 133d located in the plane area 133d_C of the oxide layer 133d may be referred to as the plane 1331, and parts of the oxide layer 133d located in the peripheral area 133d_P of the oxide layer 133d may be referred to as a plurality of protrusions 1332d. For example, side surfaces of the plurality of protrusions 1332d may define a side surface of the recess groove 133d_R.

The plurality of protrusions 1332d may be connected to the plane 1331. For example, the plurality of protrusions 1332d may be integrated with the plane 1331. For example, the plurality of protrusions 1332d and the plane 1331 may be a single body or a single pattern without a boundary interface therebetween. Each of the plurality of protrusions 1332d may extend towards the side surface of the insulating layer 131 from the side surface of the plane 1331. For example, when a first protrusion, which is one of the plurality of protrusions 1332d is in contact with a first side surface of the plane 1331, the first protrusion may extend in a direction perpendicular to the first side surface of the plane 1331.

However, the inventive concept is not limited thereto, and the first protrusion may extend in a direction inclined with respect to the first side surface of the plane 1331, and extend toward the side surface of the insulating layer 131. Each of the plurality of protrusions 1332d may extend in a horizontal direction obtained by (resulting from) combining the first horizontal direction (X direction) and the second horizontal direction (Y direction).

In some embodiments, the side surface in contact with the plane 1331 may overlap the upper surface of the insulating layer 131 in the vertical direction (Z direction). For example, in a plan view, the side surfaces of the plane 1331 and the plurality of protrusions 1332d may be arranged within the insulating pattern of the first passivation layer 130d. Among the side surfaces of the plurality of protrusions 1332d, side surfaces neighboring the side surface in contact with the plane 1331 may define the side surface of the recess groove 133d_R. For example, in a plan view, the side surfaces of the plane 1331 and the plurality of protrusions 1332d may define the side surface of the recess groove 133d_R.

Referring to FIG. 10, a first passivation layer 130e may include the insulating layer 131 and an oxide layer 133e arranged on the insulating layer 131. The oxide layer 133e may have a surface area less than the insulating layer 131, in a plan view. The side surfaces of the oxide layer 133e may overlap the upper surface of the insulating layer 131 in the vertical direction (Z direction). For example, a part of the upper surface of the insulating layer 131 may not be covered by the oxide layer 133e.

The oxide layer 133e may include a plane area 133e_C and a peripheral area 133e_P. The peripheral area 133e_P of the oxide layer 133e may surround the plane area 133e_C of the oxide layer 133e. The plane area 133e_C of the oxide layer 133e may include a center of the upper surface of the oxide layer 133e. The peripheral area 133e_P of the oxide layer 133e may include a recess groove 133e_R recessed towards the lower surface of the oxide layer 133e from the upper surface of the oxide layer 133e.

For example, a part of the oxide layer 133e located in the plane area 133e_C of the oxide layer 133e may be referred to as the plane (a first oxide pattern) 1331, and parts of the oxide layer 133e located in the peripheral area 133e_P of the oxide layer 133e may be referred to as a plurality of second oxide patterns 1332e. For example, side surfaces of the plurality of second oxide patterns 1332e may define a side surface of the recess groove 133e_R.

The plurality of second oxide patterns 1332e may be arranged apart from the plane 1331 in the horizontal direction. For example, the plane 1331 may have a rectangular cylindrical shape, and each of the plurality of second oxide patterns 1332e may have a rectangular ring shape. The plurality of second oxide patterns 1332e may surround the plane 1331. For example, the plurality of protrusions 1332e may be arranged apart from each other in the horizontal direction. The plurality of protrusions 1332e may be rectangular rings having different side lengths from each other while having the same center.

Referring to FIG. 11, a first passivation layer 130f may include the insulating layer 131 and an oxide layer 133f arranged on the insulating layer 131. The oxide layer 133f may have a surface area less than the insulating layer 131 in a plan view. The side surfaces of the oxide layer 133f may overlap the upper surface of the insulating layer 131 in the vertical direction (Z direction). For example, a part of the upper surface of the insulating layer 131 may not be covered by the oxide layer 133f.

The oxide layer 133f may include a plane area 133f_C and a peripheral area 133f_P. The peripheral area 133f_P of the oxide layer 133f may surround the plane area 133f_C of the oxide layer 133f. The plane area 133f_C of the oxide layer 133f may include a center of the upper surface of the oxide layer 133f. The peripheral area 133f_P of the oxide layer 133f may include a recess groove 133f_R recessed towards the lower surface of the oxide layer 133f from the upper surface of the oxide layer 133f.

For example, a part of the oxide layer 133f located in the plane area 133f_C of the oxide layer 133f may be referred to as the plane 1331, and a part of the oxide layer 133f located in the peripheral area 133f_P of the oxide layer 133f may be referred to as a protrusion 1332f. For example, the oxide layer 133f may be patterned to form an oxide pattern. The part of the oxide layer 133f, which is located in the peripheral area 133f_P, may be referred to as a peripheral portion 1332f of an oxide pattern. For example, side surfaces of the peripheral portion 1332f of an oxide pattern may define a side surface of the recess groove 133f_R.

The peripheral portion 1332f of an oxide pattern may be connected to the plane 1331 to form a single body. For example, the single body may have a mesh shape in a plan view. There may be a plurality of recess grooves 133f_R, and the plurality of recess grooves 133f_R may be arranged apart from each other in the horizontal direction.

FIG. 12 is a cross-sectional view schematically illustrating a semiconductor package 1000 according to an embodiment.

Referring to FIG. 12, the semiconductor package 1000 may include a first semiconductor chip 100, a second semiconductor chip (a plurality of second semiconductor chips) 200, and a molding layer ML.

In some embodiments, the first semiconductor chip 100 may include a serial-parallel conversion circuit and may be a semiconductor chip for control of the second semiconductor chip 200, and the second semiconductor chip 200 may be a memory chip including memory cells.

In some embodiments, the semiconductor package 1000 may be a high bandwidth memory (HBM), the first semiconductor chip 100 may be referred to as a HBM controller die, and the second semiconductor chip 200 may be referred to as a DRAM die.

The first semiconductor chip 100 may include the first semiconductor substrate 110, the first wiring structure 120, the plurality of first through electrodes 140, the plurality of first chip pads 130_P, and the first passivation layer 130. The first semiconductor chip 100 may be substantially identical to the first semiconductor chip (100 of FIG. 2 and 100a of FIG. 4) described above.

The first semiconductor substrate 110 may include the active surface 110_A on which a plurality of individual devices are arranged and the inactive surface 110_UA which is opposite to the active surface 110_A. For example, the active surface 110_A of the first semiconductor substrate 110 may be referred to as a front surface, and the inactive surface 110_UA of the first semiconductor substrate 110 may be referred to as a rear surface.

The first wiring structure 120 may be arranged on the active surface 110_A of the first semiconductor substrate 110. The first wiring structure 120 may be electrically connected to the plurality of individual devices on the active surface 110_A of the first semiconductor substrate 110.

The first wiring structure 120 may include the first wiring pattern 121 and the first wiring insulating layer 122 surrounding the first wiring pattern 121. The first wiring pattern 121 may include the first wiring line 121_L extending in the horizontal direction and a first wiring via 121_V extending in the vertical direction (Z direction) from the first wiring line 121_L. A part arranged at a lowermost portion of the first wiring line 121_L and exposed to the outside may be referred to as a first front pad. The external connection terminals CT may be attached to the first front pad.

For example, the semiconductor package 1000 may be a part (sub-package) of a package-in-package or a system-in-package. For example, the semiconductor package 1000 may be a part 2.5D semiconductor package. The 2.5D semiconductor package may include an interposer, on which the sub-package 1000 may be disposed. The 2.5D packaging may refer to a technology of horizontally placing semiconductor chips (or sub-packages) on a silicon interposer. For example, the external connection terminals CT of the sub-package 1000 may be disposed to contact the silicon interposer.

The plurality of first through electrodes 140 may extend to the inactive surface 110_UA of the first semiconductor substrate 110 from the active surface 110_A of the first semiconductor substrate 110. For example, the plurality of first through electrodes 140 may be connected to the plurality of individual devices of the first semiconductor substrate 110 and the first wiring structure 120.

The plurality of first chip pads 130_P may be arranged on the upper surfaces of the plurality of first through electrodes 140. In some embodiments, the width of the plurality of first chip pads 130_P may be greater than the width of the plurality of first through electrodes 140 in a horizontal direction (e.g., X direction). The plurality of first chip pads 130_P may be arranged on the inactive surface 110_UA of the first semiconductor substrate 110, and the plurality of first chip pads 130_P may be referred to as a plurality of first rear pads.

The first passivation layer 130 may be arranged on the inactive surface 110_UA of the first semiconductor substrate 110. The first passivation layer 130 may be arranged apart from the first wiring structure 120 in the vertical direction (Z direction). For example, the first passivation layer 130 may be arranged apart from the first wiring structure 120 with the first semiconductor substrate 110 located therebetween.

For example, the first passivation layer 130 may be in contact with the side surfaces of the plurality of first chip pads 130_P. The first passivation layer 130 may protect the plurality of first chip pads 130_P from the outside. For example, the first passivation layer 130 may be referred to as a rear passivation layer.

The first passivation layer 130 may include the insulating layer 131 and the oxide layer 132 arranged on the insulating layer 131. The hardness of the insulating layer 131 may be greater than the hardness of the oxide layer 132. For example, the insulating layer 131 may include a silicon nitride, and the oxide layer 132 may include a silicon oxide.

The width of the insulating layer 131 may be identical to the width of the first semiconductor substrate 110 in a horizontal direction (in a plan view), and the width of the oxide layer 132 may be less than the width of the insulating layer 131 in a horizontal direction. The side surfaces of the oxide layer 132 may overlap the upper surface of the insulating layer 131 in the vertical direction (Z direction). The side surfaces of the oxide layer 132 may be arranged apart from the side surfaces of the insulating layer 131. In some embodiments, the center of the upper surface of the oxide layer 132 and the center of the upper surface of the insulating layer 131 may be in a line in the vertical direction (Z direction). For example, in a plan view, the center of the upper surface of the oxide layer 132 may be disposed at the same location as the center of the upper surface of the insulating layer 131.

The insulating layer 131 may have the first area 131_A1 and the second area 131_A2 surrounding the first area 131_A1. The second area 131_A2 of the insulating layer 131 may include sides of the upper surface of the insulating layer 131, and the first area 131_A1 of the insulating layer 131 may include (encompass) the center of the insulating layer 131. For example, in a plan view, the second area 131_A2 of the insulating layer 131 may encompass a peripheral region of the upper surface of the insulating layer 131. The upper surface of the first area 131_A1 of the insulating layer 131 may be in contact with the oxide layer 132, and the upper surface of the second area 131_A2 of the insulating layer 131 may be in contact with the molding layer ML. For example, the central area of the insulating layer 131 may be in contact with the oxide layer 133, and the edge area of the insulating layer 131 may be in contact with the molding layer ML. A part of the upper surface of the insulating layer 131, which is located on the edge of the oxide layer 133 may be in contact with the molding layer ML.

The plurality of first through electrodes 140 and the plurality of first chip pads 130_P may overlap the first area 13 1_A1 of the first passivation layer 130 of the first semiconductor chip 100 in the vertical direction (Z direction). The plurality of first through electrodes 140 and the plurality of first chip pads 130_P may be arranged at a lower portion of the area in which the oxide layer 132 of the first passivation layer 130 is arranged.

For example, the side surface of the oxide layer 132 of the first passivation layer 130 of the first semiconductor chip 100 may be completely covered by the molding layer ML. The oxide layer 132 may not be exposed to the outside of the semiconductor package 1000. The insulating layer 131 may have better waterproofing performance than the oxide layer 132. As the oxide layer 132 is not exposed to the outside of the semiconductor package 1000, the permeation of water into the semiconductor package 1000 through the oxide layer 132 may be suppressed. Accordingly, delamination of (between) the first semiconductor chip 100 and the molding layer ML due to water may be suppressed.

The second semiconductor chip 200 may be stacked on the first semiconductor chip 100. For convenience, the case where the semiconductor package 1000 includes four second semiconductor chips 200 is described. Although FIG. 2 illustrates that in the semiconductor package 1000, four second semiconductor chips 200 are stacked on the first semiconductor chip 100, the number of second semiconductor chips 200 is not limited thereto.

The width of the second semiconductor chip 200 may be less than the width of the first semiconductor chip 100 in a horizontal direction. For example, the second semiconductor chip 200 may be stacked on the first passivation layer 130 of the first semiconductor chip 100. The second semiconductor chip 200 may overlap the first area 131_A1 of the insulating layer 131 of the first passivation layer 130 of the first semiconductor chip 100 in the vertical direction (Z direction). In some embodiments, in a horizontal direction, the width of the first area 131_A1 of the insulating layer 131 of the first passivation layer 130 may be identical to the width of the oxide layer 132, and the width of the oxide layer 132 may be identical to the width of the second semiconductor chip 200 .

The second semiconductor chip 200 may not overlap the second area 131_A2 of the insulating layer 131 of the first passivation layer 130 of the first semiconductor chip 100 in the vertical direction (Z direction). The second semiconductor chip 200 may be arranged apart from the insulating layer 131 of the first passivation layer 130 of the first semiconductor chip 100.

Hereinafter, the case where the semiconductor package 1000 includes four second semiconductor chips 200 is described for convenience. In some embodiments, a second semiconductor chip 200 located at a highest level from among the four second semiconductor chips 200 may be referred to as an uppermost second semiconductor chip 200H. A second semiconductor chip 200 located at a lowest level from among the four second semiconductor chips 200 may be referred to as a lowermost second semiconductor chip 200L.

Each of the second semiconductor chips 200 may include a second semiconductor substrate 210 and a second wiring structure 220. The thickness of the second semiconductor chip 200, i.e., the length in the vertical direction (Z direction) may be about 20 µm to about 80 µm. For example, the thickness of the uppermost second semiconductor chip 200H may be greater than the thickness of other second semiconductor chips 200.

The second semiconductor substrate 210 may include an active surface and an inactive surface opposite to the active surface. For example, the second semiconductor substrate 210 may include a semiconductor material such as silicon (Si) or germanium (Ge). The second semiconductor substrate 210 may include a compound semiconductor material such as silicon carbide (SiC), gallium arsenide (GaAs), indium arsenide (InAs), and indium phosphide (InP).

An integrated circuit including a plurality of individual devices (components) of various types may be formed on the active surface of the first semiconductor substrate 210. The plurality of individual devices formed on the first semiconductor substrate 210 may include microelectronic devices, for example, a metal-oxide-semiconductor field effect transistor (MOSFET) or complementary metal-oxide-semiconductor (CMOS) transistors. For example, the integrated circuit may include a large-scale integration (LSI), an image sensor (e.g., a CMOS imaging sensor (CIS)), a micro-electro-mechanical system (MEMS), an active device, and/or a passive device. The second wiring structure 220 may be arranged on the active surface of the second semiconductor substrate 210. The second wiring structure 220 may be electrically connected to the plurality of individual devices of the second semiconductor substrate 210.

The second wiring structure 220 may include a second wiring pattern 221 and a second wiring insulating layer 222 surrounding the second wiring pattern 221. The second wiring pattern 221 may include a second wiring line 221_L and a second wiring via 221_V. The second wiring pattern 221 may include the second wiring line 221_L extending in the horizontal direction and the second wiring via 221_V extending in the vertical direction (Z direction) from the second wiring line 221_L. A part of the second wiring line 221_L, which is located at a lowermost level and exposed to the outside of the second wiring insulating layer 222 may be referred to as a second front pad. For example, the second front pad may be formed in a recess, which is formed in a surface of the second wiring insulating layer 222.

The second semiconductor chip 200 may further include a plurality of second through electrodes 210_V extending from the inactive surface of the second semiconductor substrate 210 towards the active surface. The plurality of second through electrodes 210_V of the second semiconductor chip 200 may be electrically connected to the second wiring structure 220 of the second semiconductor chip 200.

The second semiconductor chip 200 may further include a plurality of second rear pads 230_P arranged on the inactive surface of the second semiconductor substrate 210. The plurality of second rear pads 230_P may be arranged on the plurality of second through electrodes 210_V.

The second semiconductor chip 200 may include a rear oxide layer 230 arranged on the inactive surface of the second semiconductor substrate 210. The rear oxide layer 230 may surround side surfaces of the plurality of second rear pads 230_P. The uppermost second semiconductor chip 200H may not include the plurality of second through electrodes 210_V, the plurality of second rear pads 230_P, and the rear oxide layer 230.

In some embodiments, the second semiconductor chip 200 may be arranged in such a manner that the active surface of the second semiconductor substrate 210 is directed towards the first semiconductor chip 100. For example, the second wiring structure 220 of the second semiconductor chip 200 may be directed downward in the vertical direction (Z direction), and the rear oxide layer 230 of the second semiconductor chip 200 may be directed upward in the vertical direction.

In some embodiments, the lowermost second semiconductor chip 200L may be in contact with the oxide layer 132 of the first semiconductor chip 100. For example, in a horizontal direction, the width of the second semiconductor chip 200 may be identical to the width of the oxide layer 132 of the first passivation layer 130 of the first semiconductor chip 100. For example, the side surfaces of the second semiconductor chip 200 may overlap the upper surface of the insulating layer 131of the first passivation layer 130 of the first semiconductor chip 100 in the vertical direction (Z direction).

The adhesive force between the molding layer ML and the insulating layer 131 of the first passivation layer 130 may be stronger than the adhesive force between the molding layer ML and the oxide layer 132 of the first passivation layer 130. For example, the oxide layer 132 of the first passivation layer 130 of the first semiconductor chip 100 may be present only in a portion on which the second semiconductor chip 200 is to be mounted and may not be present in other portions. Accordingly, by arranging the oxide layer 132 of the first passivation layer 130 only in a portion on which the second semiconductor chip 200 is to be mounted, the first semiconductor chip 100 and the second semiconductor chip 200 may be hybrid-bonded to each other, and by removing the oxide layer in other areas, the adhesive force between the molding layer ML and the first semiconductor chip 100 may be improved.

The plurality of first chip pads 130_P of the first semiconductor chip 100 and the plurality of second front pads of the second wiring structure 220 of the lowermost second semiconductor chip 200L may be diffusion-bonded by heat and may be integrated. For example, each of the plurality of first chip pads 130_P of the first semiconductor chip 100 may be bonded integrally to a corresponding one of the plurality of second front pads of the second wiring structure 220 of the lowermost second semiconductor chip 200L, without a boundary interface therebetween. During the diffusion bonding of the plurality of first chip pads 130_P and the second front pads by heat, the oxide layer 132 of the first passivation layer 130 of the first semiconductor chip 100 and the second wiring insulating layer 222 of the second wiring structure 220 of the lowermost second semiconductor chip 200L may be covalent-bonded by heat and may be integrated. In some embodiments, the first semiconductor chip 100 and the second semiconductor chip 200 may be combined with each other through hybrid-bonding.

In some embodiments, the combination (bonding) method of the second semiconductor chips 200 may be substantially identical to the combination method of the first semiconductor chip 100 and the lowermost second semiconductor chip 200L. For example, the bonding between a pair of the second semiconductor chips 200H, 200M2, 200M1 and 200L may be performed by the same method as the bonding between the second semiconductor chip 200M1 and the first semiconductor chip 100. Hereinafter, the bonding of the lower second semiconductor chips 200M1 and 200L are described as an example.

The plurality of second rear pads 230_P located on the upper surface of the second semiconductor chip 200L and the plurality of second front pads located on the lower surface of the second semiconductor chip 200L may be diffusion-bonded to each other and may be integrated. During the diffusion-bonding of the plurality of second rear pads 230_P and the plurality of second front pads, the rear oxide layer 230 of the second semiconductor chip 200L and the second wiring insulating layer 222 of the second wiring structure 220 of the second semiconductor chip 200M1 may be covalent-bonded to each other and may be integrated.

The molding layer ML may be arranged on the first semiconductor chip 100 and may be in contact with at least a part of the side surface of the second semiconductor chip 200. For example, the molding layer ML may completely surround the side surfaces of the second semiconductor chip 200. The upper surface of the molding layer ML may be coplanar with the upper surface of the uppermost second semiconductor chip 200H.

The molding layer ML may be in contact with the side surface of the oxide layer 132 and the upper surface of the second area 131_A2 of the insulating layer 131 of the first passivation layer 130 of the first semiconductor chip 100. In some embodiments, the molding layer ML may include epoxy resin, polyimide resin, etc. The molding layer ML may include, for example, an epoxy molding compound (EMC).

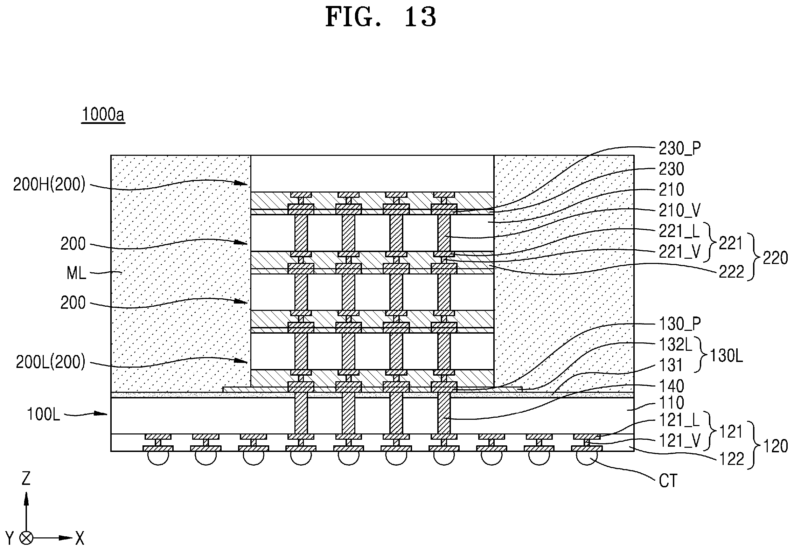

FIG. 13 is a cross-sectional view schematically illustrating a semiconductor package 1000a according to an embodiment.

Most of the components constituting the semiconductor package 1000a and the materials included in the components described below may be substantially identical or similar to the components and materials described above with reference to FIG. 12. Accordingly, for convenience, embodiments are described focusing on differences between the semiconductor package 1000a of FIG. 13 and the semiconductor package 1000 of FIG. 12.

Referring to FIG. 13, the semiconductor package 1000a may include a first semiconductor chip 100L, second semiconductor chips 200, and the molding layer ML. The second semiconductor chip 200 may be stacked on the first semiconductor chip 100L. The molding layer ML may be arranged on the first semiconductor chip 100L and may be in contact with the side surface of the second semiconductor chip 200.

In some embodiments, in a plan view, the surface area of the lower surface of the second semiconductor chip 200 may be less than the surface area of the lower surface of the first semiconductor chip 100L. In some embodiments, the side surfaces of the second semiconductor chip 200 may overlap the upper surface of the first semiconductor chip 100L in the vertical direction (Z direction).

A first passivation layer 130L may include the insulating layer 131 and an oxide layer 132L. The width of the oxide layer 132L may be less than the width of the insulating layer 131 in a horizontal direction. The side surfaces of the oxide layer 132L may overlap the upper surface of the insulating layer 131 in the vertical direction (Z direction). For example, in a plan view, the side surfaces of the first oxide pattern of the oxide layer 132L may be arranged within the insulating pattern of the insulating layer 131. For example, in a plan view, the side surfaces of the first oxide pattern of the oxide layer 132L may protrude in a horizontal direction beyond the side surface of the second semiconductor chip 200.

The second semiconductor chip 200 may be arranged on the first passivation layer 130L of the first semiconductor chip 100L. The second semiconductor chip 200 may be arranged on the oxide layer 132L of the first passivation layer 130L of the first semiconductor chip 100L and may be in contact with the oxide layer 132L. The second semiconductor chip 200 may be arranged apart from the insulating layer 131 of the first passivation layer 130L of the first semiconductor chip 100L in the vertical direction (Z direction).

The width of the oxide layer 132L of the first passivation layer 130L may be greater than the width of the second semiconductor chip 200 in a plan view (in a horizontal direction). For example, the surface area of the upper surface of the oxide layer 132L of the first passivation layer 130L may be greater than the surface area of the lower surface of the second semiconductor chip 200. The width of the insulating layer 131 of the first passivation layer 130L may be greater than the width of the oxide layer 132L and the width of the second semiconductor chip 200.

The side surfaces of the oxide layer 132L of the first passivation layer 130L may be arranged on the upper surface of the first passivation layer 130L, and the side surfaces of the second semiconductor chip 200 may be arranged on the upper surface of the oxide layer 132L of the first passivation layer 130L. For example, a part of the upper surface of the insulating layer 131 of the first passivation layer 130L may be in contact with the molding layer ML, and a part of the upper surface of the oxide layer 132L of the first passivation layer 130L may be in contact with the molding layer ML.

As the surface area of the oxide layer 132L of the first passivation layer 130L is greater than the surface area of the second semiconductor chip 200, in the process of combining (bonding) the second semiconductor chip 200 onto the oxide layer 132L of the first passivation layer 130L of the first semiconductor chip 100L, the level of difficulty of combination process may be lowered such that alignment tolerance may be increased.

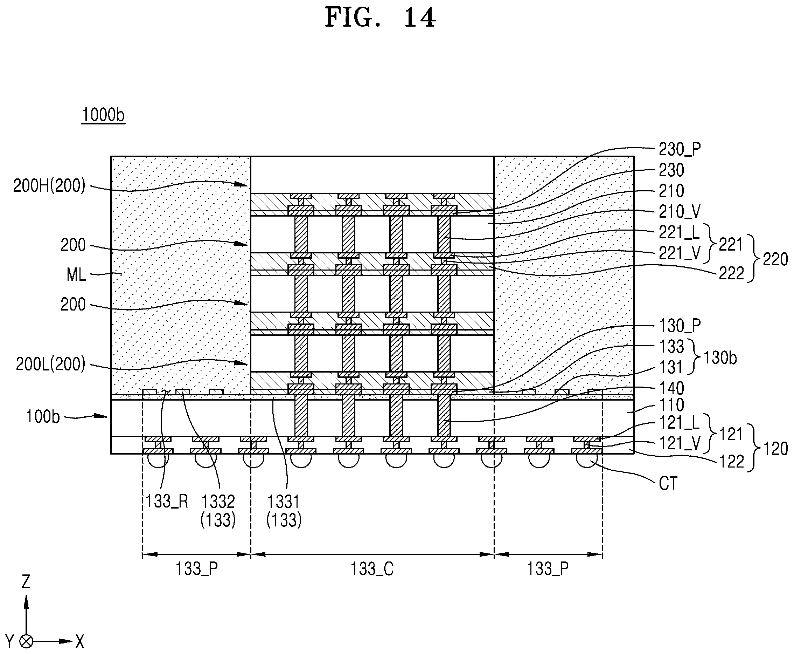

FIG. 14 is a cross-sectional view schematically illustrating a semiconductor package 1000b according to an embodiment.

Most of the components constituting the semiconductor package 1000b and the materials included in the components described below may be substantially identical or similar to the components and materials described above with reference to FIG. 12. Accordingly, for convenience, embodiments are described focusing on differences between the semiconductor package 1000b of FIG. 14 and the semiconductor package 1000 of FIG. 12.

Referring to FIG. 14, the semiconductor package 1000b may include the first semiconductor chip 100b, the second semiconductor chip 200, and the molding layer ML. The second semiconductor chip 200 may be stacked on the first semiconductor chip 100b. The molding layer ML may be arranged on the first semiconductor chip 100b and may be in contact with the side surface of the second semiconductor chip 200. The first semiconductor chip 100b may be the first semiconductor chip (100b of FIG. 6, 100c of FIG. 8, 100d of FIG. 9, 100e of FIG. 10, or 100f of FIG. 11) described above.

The second semiconductor chip 200 may be arranged on the first passivation layer 130b of the first semiconductor chip 100b. The first passivation layer 130b may include the insulating layer 131 and the oxide layer 133 arranged on the insulating layer 131. The width of the oxide layer 133 may be less than the width of the insulating layer 131. The side surfaces of the oxide layer 133 may overlap the upper surface of the insulating layer 131 in the vertical direction (Z direction).

In some embodiments, a part of the insulating layer 131, which is not covered by the second semiconductor chip 200 may be in contact with the molding layer ML. For example, a part of the insulating layer 131 of the first passivation layer 130b, which is not covered by the oxide layer 133 may be in contact with the molding layer ML. The central area of the insulating layer 131 may be in contact with the oxide layer 133, and a part of the edge area of the insulating layer 131 may be in contact with the molding layer ML.

The central area of the insulating layer 131 may include (encompass) the center of the upper surface of the insulating layer 131 in a plan view, and the edge area of the insulating layer 131 may include the sides of the upper surface of the insulating layer 131. The second semiconductor chip 200 may be located on the central area of the insulating layer 131.

The oxide layer 133 may include the plane area 133_C and the peripheral area 133_P surrounding the plane area 133_C. The plane area 133_C may be arranged on the central area of the insulating layer 131. In a plan view, the plurality of first chip pads 130_P are arranged within a part of the oxide layer 133, which is located in the plane area 133_C. In the plane area 133_C, the part of the oxide layer 133, along with the plurality of first chip pads 130_P, may have a surface of an unrecessed flat shape. In the peripheral area 133_P of the oxide layer 133, the recess groove (opening) 133_R recessed towards the lower surface of the oxide layer 133 from the upper surface of the oxide layer 133 may be arranged. For example, in the peripheral area 133_P of the oxide layer 133, the upper surface of the insulating layer 131 located at a lower portion of the recess groove 133_R may face (be in contact with) the molding layer ML.

A part of the oxide layer 133, which is located in the plane area 133_C of the oxide layer 133 may be referred to as the plane (or first oxide pattern) 1331, and parts of the oxide layer 133, which is located in the peripheral area 133_P of the oxide layer 133 may be referred to as a plurality of protrusions (or second oxide patterns) 1332.

The upper surface of the insulating layer 131 may be in contact with at least one of the plane 1331 of the oxide layer 133, the plurality of protrusions 1332, and the molding layer ML. For example, a part of the upper surface of the insulating layer 131, which is located on the edge of the oxide layer 133 and a part located at a lower portion of the recess groove 133_R may be in contact with the molding layer ML.

A part of the molding layer ML may be located between the plurality of protrusions 1332 of the oxide layer 133 of the first passivation layer 130b of the first semiconductor chip 100b. For example, the molding layer ML may be in contact with a side surface of the plurality of protrusions 1332. The side and upper surfaces of the plurality of protrusions 1332 may be surrounded by the molding layer ML. A part of the molding layer ML, which is located between the plurality of protrusions 1332 (i.e., a part of the molding layer ML located in the recess groove 133_R) may be in contact with the upper surface of the insulating layer 131 of the first passivation layer 130b of the first semiconductor chip 100b.

The second semiconductor chip 200 may overlap the plane area 133_C of the oxide layer 133 of the first passivation layer 130b of the first semiconductor chip 100b in the vertical direction. The second semiconductor chip 200 may be arranged in the plane area 133_C of the oxide layer 133 of the first passivation layer 130b of the first semiconductor chip 100b. For example, the second wiring insulating layer 222 of the second wiring structure 220 of the second semiconductor chip 200 and the plane 1331 of the first passivation layer 130b of the first semiconductor chip 100b may be covalent-bonded to each other.

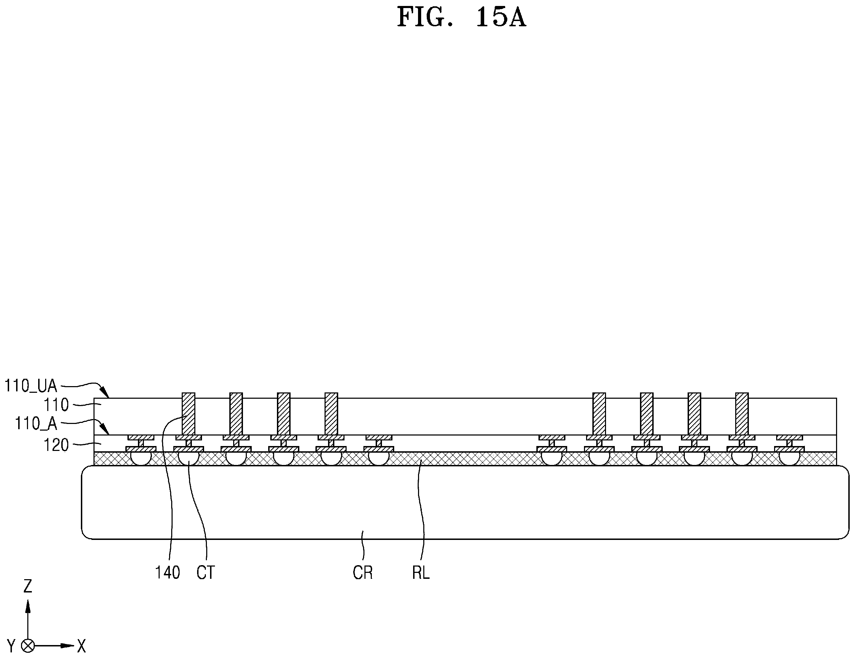

FIGS. 15A to 15G are each a diagram illustrating a method of manufacturing the semiconductor package 1000a, according to an embodiment. FIGS. 15A to 15G each illustrate a method of manufacturing the semiconductor package 1000a of FIG. 12.

Referring to FIGS. 15A to 15G, the method of manufacturing a semiconductor package may include mounting the first semiconductor substrate 110 on a carrier substrate CR, forming the first passivation layer 130 on the inactive surface 110_UA of the first semiconductor substrate 110, forming the plurality of first chip pads 130_P on the inactive surface 110_UA of the first semiconductor substrate 110, forming in the first passivation layer 130 a trench 130L_T extending from the upper surface of the first passivation layer 130L to the inside of the first passivation layer 130L, mounting the second semiconductor chip 200 on the first semiconductor chip 100L, and forming the molding layer ML on the first semiconductor chip 100L to surround the side surface of the second semiconductor chip 200.

Referring to FIG. 15A, the first semiconductor substrate 110 may be mounted on the carrier substrate CR. In some embodiments, the first semiconductor substrate 110 may be a wafer which has not been cut into a plurality of dies.

The first semiconductor substrate 110 may include an active surface 100_A and the inactive surface 110_UA opposite to the active surface 100_A. The first wiring structure 120 may be located on the active surface 100_A of the first semiconductor substrate 110. The plurality of first through electrodes 140 may extend to the inactive surface 110_UA of the first semiconductor substrate 110 from the active surface 100_A of the first semiconductor substrate 110.

Before mounting the first semiconductor substrate 110 on the carrier substrate CR, the first wiring structure 120 and the plurality of first through electrodes 140 may be formed on the first semiconductor substrate 110. The first semiconductor substrate 110 may be attached onto the carrier substrate CR after the first wiring structure 120 and the plurality of first through electrodes 140 are formed on the first semiconductor substrate 110. In some embodiments, the first semiconductor substrate 110 may be attached onto the carrier substrate CR through an adhesive film RL.

For example, the first semiconductor substrate 110 may be attached onto the carrier substrate CR such that the active surface 100_A of the first semiconductor substrate 110 is directed towards the carrier substrate CR. In some embodiments, the first semiconductor substrate 110 may be attached onto the carrier substrate CR after the external connection terminals CT are attached to the first wiring structure 120. However, the inventive concept is not limited thereto, and the external connection terminals CT may be attached in a subsequent process.

In some embodiments, the plurality of first through electrodes 140 may pass through the first semiconductor substrate 110. For example, a part of each of the plurality of first through electrodes 140 may protrude over the inactive surface 110_UA of the first semiconductor substrate 110.

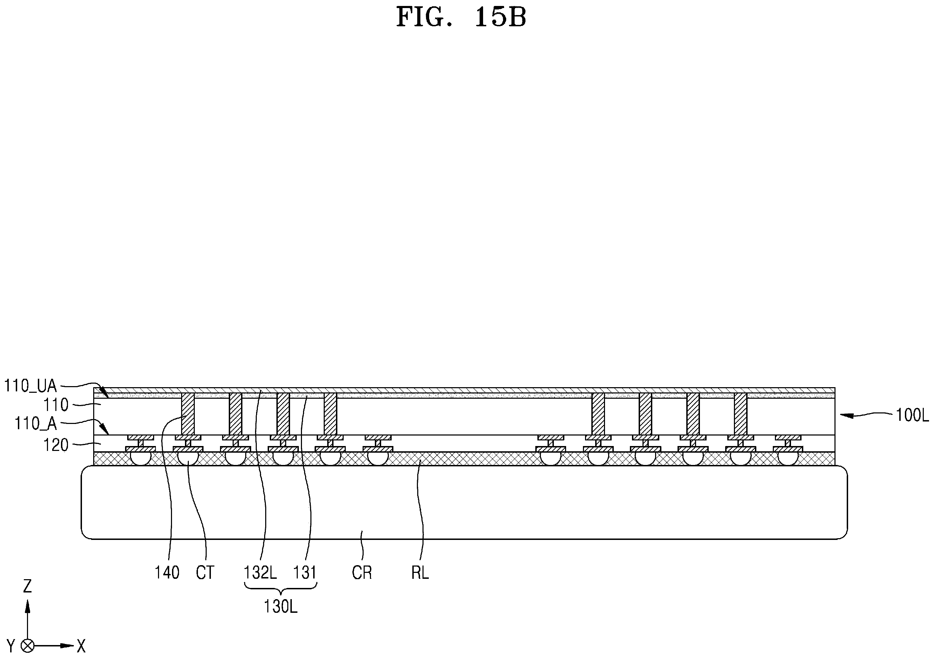

Referring to FIG. 15B, the first passivation layer 130L may be formed on the inactive surface 110_UA of the first semiconductor substrate 110. For example, the first passivation layer 130L may be referred to as a first rear passivation layer.

The forming of the first passivation layer 130L may include forming the insulating layer 131 on the inactive surface 1 10_UA of the first semiconductor substrate 110 and forming the oxide layer 132L on the insulating layer 131. For example, the insulating layer 131 may be conformally formed on the inactive surface 110_UA to cover the inactive surface 110_UA of the first semiconductor substrate 110, and the oxide layer 132L may be conformally formed on the upper surface of the insulating layer 131 to cover the insulating layer 131 of the oxide layer 132L. The upper surface of the insulating layer 131 may be in contact with the oxide layer 132L, and the lower surface of the insulating layer 131 may be in contact with the first semiconductor substrate 110.

In some embodiments, the first passivation layer 130L may surround a part of the plurality of first through electrodes 140, which protrudes towards the inactive surface 110_UA of the first semiconductor substrate 110.

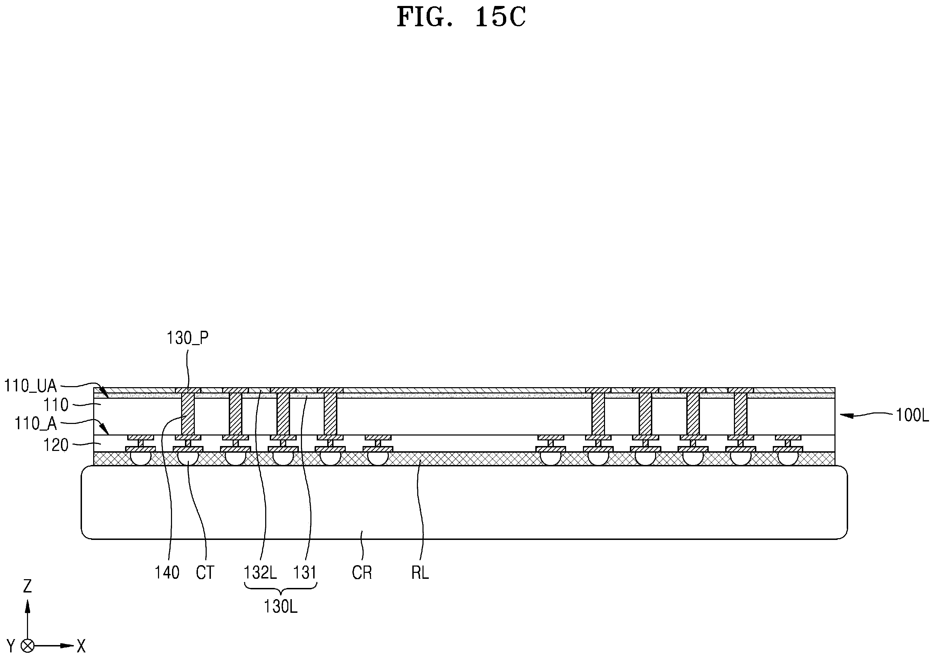

Referring to FIG. 15C, the plurality of first chip pads 130_P may be formed on the first passivation layer 130L. The plurality of first chip pads 130_P may be arranged on the inactive surface 110_UA of the first semiconductor substrate 110. The plurality of first chip pads 130_P may be referred to as a plurality of first rear pads.

The plurality of first chip pads 130_P may be electrically connected to the plurality of first through electrodes 140. In some embodiments, the plurality of first chip pads 130_P may respectively be in physical contact with the plurality of first through electrodes 140. For example, the plurality of first chip pads 130_P may respectively be integrated with the plurality of first through electrodes 140.

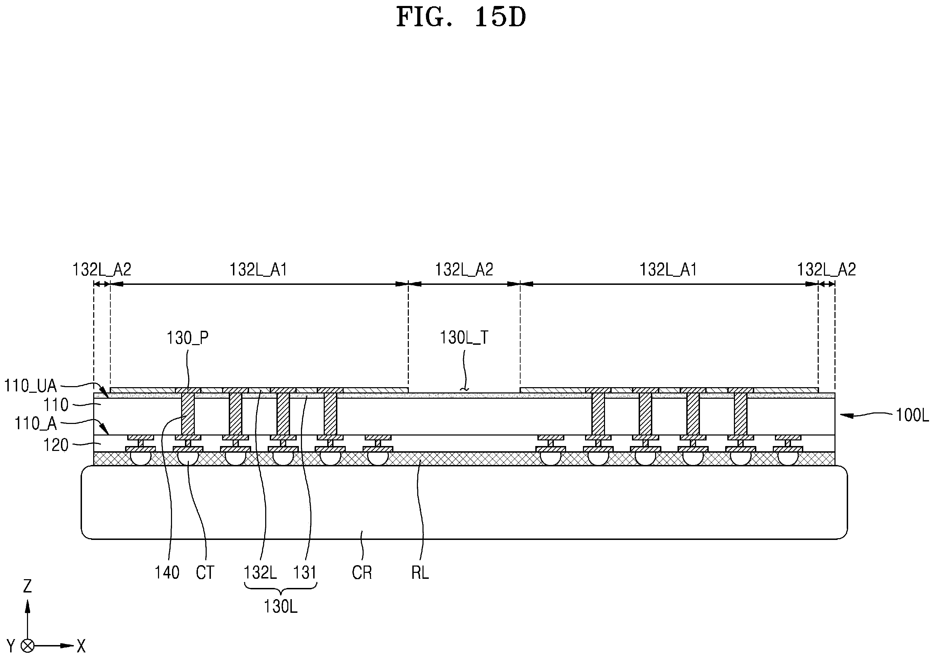

Referring to FIG. 15D, the trench 130L_T may be formed in the first passivation layer 130L. The trench 130L_T may extend from the upper surface of the first passivation layer 130L to the inside of the first passivation layer 130L. For example, the trench 130L_T may not completely pass through the first passivation layer 130L and may partially pass through the first passivation layer 130L.

The trench 130L_T may extend from the upper surface of the oxide layer 132L of the first passivation layer 130L to the lower surface of the oxide layer 132L such that the upper surface of the insulating layer 131 of the first passivation layer 130L may be partially exposed. For example, the insulating layer 131 may be exposed to the outside through the trench 130L_T.

The trench 130L_T may be arranged apart from the plurality of first chip pads 130_P. For example, the trench 130L_T may not overlap the plurality of first chip pads 130_P and the plurality of first through electrodes 140 in the vertical direction (Z direction). The side surfaces of the plurality of first chip pads 130_P may be in contact with the oxide layer 132L of the first passivation layer 130L.

In some embodiments, the trench 130L_T may be formed by partially removing the oxide layer 132L through the photo and patterning process. Accordingly, the horizontal width of the remaining oxide layer 132L may increase towards the insulating layer 131. In addition, as the insulating layer 131 is partially removed along with the oxide layer 132L, the upper surface of the insulating layer 131, which is exposed to the outside by the trench 130L_T may have a downward-concave shape.

In some embodiments, an area of the insulating layer 131 of the first passivation layer 130L, in which the oxide layer 132L is present, may be referred to as a first area 132L_A1 of the insulating layer 131 and an area of the insulating layer 131, which is exposed by the trench 130L_T, may be referred to as a second area 132L_A2. In some embodiments, the second area 132L_A2 of the insulating layer 131 may be an edge area of the insulating layer 131 of the first passivation layer 130L of one first semiconductor chip 100L after the first semiconductor substrate 110 is cut. For example, in the process of forming the trench 130L_T, the oxide layer 132L located on the edge area of the insulating layer 131 of the first passivation layer 130L of the first semiconductor chip 100L may be removed.

The first wiring structure 120, the first semiconductor substrate 110, the plurality of first through electrodes 140, the plurality of first chip pads 130_P, and the first passivation layer 130L may be collectively referred to as the first semiconductor chip 100L.

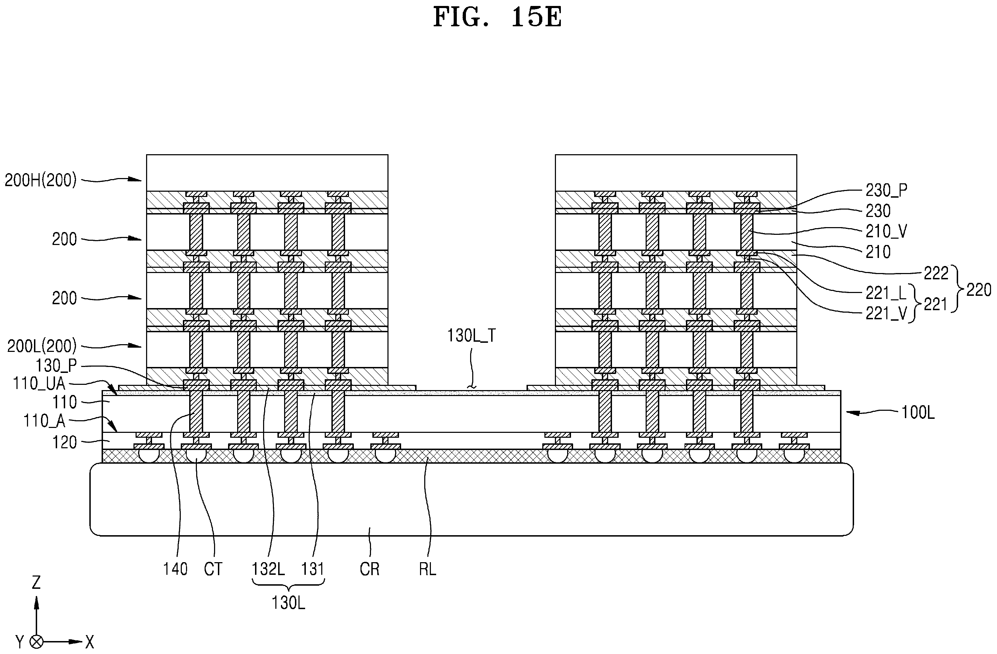

Referring to FIG. 15E, the second semiconductor chips 200 may be stacked on the first semiconductor chip 100L. The second semiconductor chips 200 may be arranged on the oxide layer 132L of the first passivation layer 130L of the first semiconductor chip 100L.

The plurality of second semiconductor chips 200 may be sequentially stacked and mounted on the first semiconductor chip 100L. The second semiconductor chip 200 may be mounted at an upper portion of the first area 132L_A1 of the insulating layer 131 of the first passivation layer 130L of the first semiconductor chip 100L. The width of the second semiconductor chip 200 may be less than the width of the oxide layer 132L of the first passivation layer 130L of the first semiconductor chip 100L. The second semiconductor chip 200 may be arranged apart from the insulating layer 131 of the first passivation layer 130L of the first semiconductor chip 100L in the vertical direction (Z direction).

In some embodiments, the second wiring insulating layer 222 of the second wiring structure 220 of the second semiconductor chip 200 may be integrated (or bonded) with the oxide layer 132L of the first passivation layer 130L of the first semiconductor chip 100L by covalent bonding. The plurality of second front pads of the second semiconductor chip 200 may be integrated with the plurality of first chip pads 130_P of the first semiconductor chip 100L by diffusion bonding. For example, the second semiconductor chip 200 may be combined with (e.g., bonded to) the first semiconductor chip 100L by hybrid bonding.

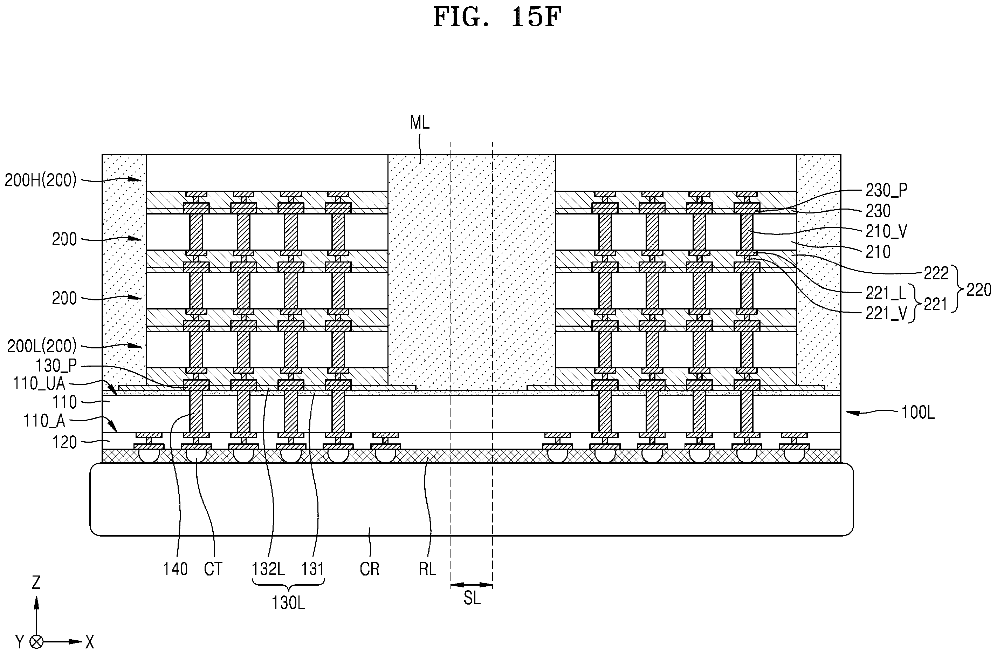

Referring to FIG. 15F, the molding layer ML may be formed on the first semiconductor chip 100L to be in contact with the side surface of the second semiconductor chip 200. For example, after the molding layer ML is formed on the first passivation layer 130L of the first semiconductor chip 100L to cover the second semiconductor chip 200, the molding layer ML may be partially removed until the upper surface of the uppermost second semiconductor chip 200 is exposed.

The molding layer ML may fill the trench 130L_T of the first passivation layer 130L of the first semiconductor chip 100L. For example, the molding layer ML may be in contact with the upper surface of the second area 132L_A2 of the insulating layer 131 of the first passivation layer 130L of the first semiconductor chip 100L. In addition, the molding layer ML may be in contact with the upper surface of the oxide layer 132L of the first passivation layer 130L of the first semiconductor chip 100L, which is not covered by the second semiconductor chip 200.

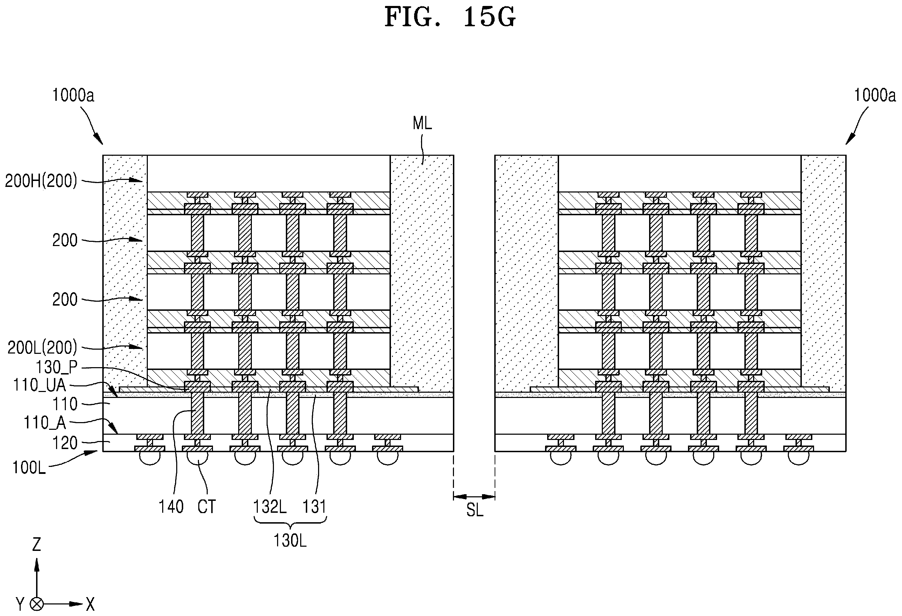

Referring to FIG. 15G, cutting the result of FIG. 15F along a sawing lane SL may be performed, and the adhesive film RL and the carrier substrate CR may be removed, thereby manufacturing a plurality of semiconductor packages 1000a.

For example, the molding layer ML, the insulating layer 131 of the first passivation layer 130L, the first semiconductor substrate 110, and the first wiring structure 120 may be cut along the sawing lane SL to manufacture the plurality of semiconductor packages 1000a. The side surface of the semiconductor package 1000a may be determined along the sawing lane SL. As a result of the cutting, the side surfaces of the semiconductor substrate may be aligned with side surfaces of the insulating pattern of the passivation layer in a vertical direction.

The sawing lane SL may be arranged apart from the oxide layer 132L of the first passivation layer 130L in the horizontal direction. For example, the oxide layer 132L may not be exposed to the outside of the semiconductor package 1000a. The side surface of the semiconductor package 1000a may not include the side surface of the oxide layer 132L. The side surface of the oxide layer 132L may be located inside the semiconductor package 1000a.

While the inventive concept has been particularly shown and described with reference to embodiments thereof, it will be understood that various changes in form and details may be made therein without departing from the scope of the following claims.

## Claims

1. A semiconductor chip comprising:
a semiconductor substrate (110) including a first surface (110_A) and a second surface (110_UA) opposite to the first surface (110_A);
a wiring layer (120) arranged on the first surface (110_A) of the semiconductor substrate (110);
a plurality of through electrodes (140) extending from the first surface (110_A) of the semiconductor substrate (110) to the second surface (110_UA) of the semiconductor substrate (110);
a plurality of chip pads (130_P) arranged on the second surface (110_UA) of the semiconductor substrate (110) and electrically connected to the plurality of through electrodes (140); and
a passivation layer (130; 130a; 130b; 130c; 130d; 130e; 130f) arranged on the second surface (110_UA) of the semiconductor substrate (110) and in contact with side surfaces of the plurality of chip pads (130 _P),
wherein:
the passivation layer (130; 130a; 130b; 130c; 130d; 130e; 130f) includes an insulating layer (131) and an oxide layer (132; 133; 133d; 133e; 133f) arranged on the insulating layer (131),
the insulating layer (131) includes an insulating pattern having a first width along a horizontal direction,
the oxide layer (132; 133; 133d; 133e; 133f) includes a first oxide pattern (1331; 1331d; 1331e; 1331f) having a second width along the horizontal direction, and
the first width is greater than the second width.

2. The semiconductor chip of claim 1, wherein:
the insulating layer (131) of the passivation layer (130; 130a; 130b; 130c; 130d; 130e; 130f) has a first area and a second area in a plan view,
in the first area (131_A1) of the insulating layer (131), an upper surface of the insulating layer (131) is covered by the oxide layer (132; 133), and
in the second area (131_A2) of the insulating layer (131), the upper surface of the insulating layer (131) is exposed with respect to the oxide layer (132; 133).

3. The semiconductor chip of claim 2, wherein:
in the first area (131_A1) of the insulating layer (131) of the passivation layer (130), the upper surface of the insulating layer (131) is flat, and
in the second area (131_A2) of the insulating layer (131) of the passivation layer (130), the upper surface of the insulating layer (131) is downward-concave.

4. The semiconductor chip of claim 2 or 3, wherein the plurality of through electrodes (140) and the plurality of chip pads (130_P) overlap the first area (131_A1) of the insulating layer (131) of the passivation layer (130) in a vertical direction (Z) and are arranged apart from the second area (131_A2) of the insulating layer (131) of the passivation layer (130) in a horizontal direction.

5. The semiconductor chip of claim 4, wherein an upper surface of each of the plurality of chip pads (130_P) is coplanar with an upper surface of the oxide layer (130; 130a; 130b; 130c; 130d; 130e; 130f) of the passivation layer (130).

6. The semiconductor chip of any one of claims 1 to 5, wherein:
side surfaces of the semiconductor substrate (110) are aligned with side surfaces of the insulating pattern of the passivation layer (130; 130a; 130b; 130c; 130d; 130e; 130f) in a vertical direction (Z), and
in a plan view, side surfaces of the first oxide pattern (1331; 1331d; 1331e; 1331f) of the passivation layer (130; 130a; 130b; 130c; 130d; 130e; 130f) are arranged within the insulating pattern of the passivation layer (130).

7. The semiconductor chip of any one of claims 1 to 6, wherein a hardness of the insulating layer (131) of the passivation layer (130; 130a; 130b; 130c; 130d; 130e; 130f) is greater than a hardness of the oxide layer (130; 130a; 130b; 130c; 130d; 130e; 130f).

8. The semiconductor chip of any one of claims 1 to 7, wherein:
the passivation layer (130a; 130c) further comprises an intermediate oxide layer (134), and
the intermediate oxide layer (134) is arranged between the insulating layer (131) of the passivation layer (130) and the second surface (110_UA) of the semiconductor substrate (110).

9. The semiconductor chip of any one of claims 1 to 8, wherein:
a surface area of an upper surface of the oxide layer (133; 133d; 133e; 133f) is less than a surface area of an upper surface of the insulating layer (131),
the semiconductor substrate (110) has a first region and a second region surrounding the first region in a plan view,
the first region has a rectangular shape in a plan view,
the oxide layer (133; 133d; 133e; 133f) is disposed on the first and second regions,
the oxide layer (133; 133d; 133e; 133f) includes an opening (133_R; 133d_R; 133e_R; 133f_R) located on the second region,
the opening (133_R; 133d_R; 133e_R; 133f_R) is recessed from the upper surface of the oxide layer (133) to a lower surface of the oxide layer (133; 133d; 133e; 133f), and
in a plan view, side surfaces of the first oxide pattern (1331; 1331d; 1331e; 1331f) are arranged within the insulating pattern, and are arranged apart from side surfaces of the insulating pattern (131).

10. The semiconductor chip of claim 11, wherein:
a part of the upper surface of the insulating layer (131) of the passivation layer (130b; 130c; 130d; 130e; 130f), which is located at a lower portion of the opening (133_R), and
a part of the upper surface of the insulating layer (131) of the passivation layer (130b; 130c; 130d; 130e; 130f), which is located on an edge of the oxide layer, is exposed with respect to the oxide layer.

11. The semiconductor chip of claim 12, wherein the exposed part of the upper surface of the insulating layer of the passivation layer has a downward-concave shape.

12. The semiconductor chip of claim 11, wherein:
the oxide layer includes a plurality of second oxide patterns (1332; 1332d; 1332e; 1332f) arranged apart from the first oxide pattern (1331; 1331d; 1331e; 1331f) in a horizontal direction,
the first oxide pattern (1331; 1331d; 1331e; 1331f) is located on the first region,
the plurality of second oxide patterns (1332; 1332d; 1332e; 1332f) are located on the second region, and
the plurality of second oxide patterns (1332; 1332d; 1332e; 1332f) are apart from each other in the horizontal direction.

13. The semiconductor chip of claim 11 or 12, wherein:
the oxide layer (133d) includes a plurality of protrusions which extend from the first region in a plan view, and
the plurality of protrusions extend in a direction to the side surfaces of the insulating pattern from an edge of the first region in a plan view.

14. The semiconductor chip of any one of claims 11 to 13, wherein:
the oxide layer (133e) includes a second oxide pattern (1332e) arranged apart from the first oxide pattern (1331) in a horizontal direction,
the first oxide pattern (1331) is located on the first region,
the second oxide pattern (1332e) is located on the second region, and
the second oxide pattern (1332e) has a rectangular ring shape.

15. A semiconductor package comprising:
a first semiconductor chip (100; 100L; 100b) according to any one of the preceding claims;
a second semiconductor chip (200L) stacked on the first semiconductor chip (100; 100L; 100b) and having a width less than a width of the first semiconductor chip (100; 100L; 100b); and
a molding layer (ML) arranged on the passivation layer (130; 130L; 130b) of the first semiconductor chip (100; 100L; 100b) and in contact with at least a part of a side surface of the second semiconductor chip (200L),
wherein:
in a plan view, side surfaces of the first oxide pattern (1331; 1331d; 1331e; 1331f) of the passivation layer (130; 130L; 130b) are arranged within the insulating pattern of the passivation layer (130; 130L; 130b), and
the second semiconductor chip (200L) is in contact with the first oxide pattern (1331; 1331d; 1331e; 1331f) of the passivation layer (130; 130L; 130b) of the first semiconductor chip (100; 100L; 100b).
